(19) Europäisches Patentamt
European Patent Office
Office européen des brevets

(11) **EP 4 503 258 A1**

(12) **EUROPEAN PATENT APPLICATION**
published in accordance with Art. 153(4) EPC

(43) Date of publication:
**05.02.2025 Bulletin 2025/06**

(21) Application number: 23780704.5

(22) Date of filing: **29.03.2023**

(51) International Patent Classification (IPC):
*H01M 10/48* (2006.01)   *G01R 31/00* (2006.01)
*H01M 10/42* (2006.01)   *H02J 7/00* (2006.01)

(52) Cooperative Patent Classification (CPC):
**G01R 31/00; H01M 10/42; H01M 10/48; H02J 7/00;**
Y02E 60/10

(86) International application number:
**PCT/JP2023/012834**

(87) International publication number:
**WO 2023/190695 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.03.2022  JP 2022059580**

(71) Applicants:
• **FURUKAWA ELECTRIC CO., LTD.**
  **Tokyo 100-8322 (JP)**
• **Furukawa Automotive Systems Inc.**
  **Inukami-gun, Shiga 522-0242 (JP)**

(72) Inventors:
• **KOJIMA, Hiroshi**
  **Inukami-gun, Shiga 522-0242 (JP)**
• **KOGA, Takahiro**
  **Inukami-gun, Shiga 522-0242 (JP)**
• **KAWARAGI, Shinji**
  **Inukami-gun, Shiga 522-0242 (JP)**

(74) Representative: **Horn Kleimann Waitzhofer
Schmid-Dreyer
Patent- und Rechtsanwälte PartG mbB
Theresienhöhe 12
80339 München (DE)**

(54) **BATTERY CONTROL MONITORING SYSTEM, BATTERY CONTROL MONITORING DEVICE, BATTERY CONTROL MONITORING METHOD, BATTERY CONTROL MONITORING PROGRAM, AND STORAGE MEDIUM**

(57)     A battery control monitoring system (2) comprises a discharge circuit (20), a controller (15), and a fixation monitoring circuit (24). The discharge circuit (20) is configured to execute a forced discharge of the rechargeable battery (11) while charging and discharging of the rechargeable battery (11) stop. The controller (15) is electrically connected to the discharge circuit (20) and is configured to control the forced discharge executed by the discharge circuit (20) using a control signal (CS). The fixation monitoring circuit (24) is electrically connected to the controller (15) and is configured to monitor signal fixation.

**FIG. 3**

## Description

Technical Field

The technology disclosed in the present application relates to a battery control monitoring system, a battery control monitoring device, a battery control monitoring method, a battery control monitoring program, and a storage medium.

Background Art

Patent Literature 1 describes a secondary-battery-state detection device that detects the state of a lead-acid battery. The device described in Patent Literature 1 determines the state of the secondary battery by performing pulse discharge on the secondary battery.

Citation List

Patent Literature

Patent Literature 1: JP 2014 - 178213 A

Summary of Invention

Technical Problem

However, there is a possibility that signal fixation may occur due to a malfunction in at least one of the discharge circuit and the control unit. The signal fixation affects the control of the discharge circuit, potentially reducing the accuracy of arithmetic processing performed using forced discharge executed by the discharge circuit. The device described in Patent Literature 1 does not consider the signal fixation.

An object of the technology disclosed in the present application is, for example, to provide a battery control monitoring system, a battery control monitoring device, a battery control monitoring method, a battery control monitoring program, and a storage medium that can suppress the reduction in the accuracy of arithmetic processing performed using forced discharge executed by the discharge circuit.

Another object of the technology disclosed in the present application is, for example, to provide a battery control monitoring system, a battery control monitoring device, a battery control monitoring method, a battery control monitoring program, and a storage medium that can detect in advance the occurrence of malfunction due to signal fixation.

Solution to Problem

In accordance with a first aspect, a battery control monitoring system comprises a discharge circuit, a controller, and a fixation monitoring circuit. The discharge circuit is configured to execute forced discharge of a rechargeable battery. The controller is electrically connected to the discharge circuit and is configured to control the forced discharge executed by the discharge circuit using a control signal. The fixation monitoring circuit is electrically connected to the controller and is configured to monitor signal fixation.

With the battery control monitoring system according to the first aspect, since the signal fixation can be monitored using the fixation monitoring circuit, a malfunction of at least one of the discharge circuit and the controller can be detected. Accordingly, the reduction in the accuracy of arithmetic processing using the forced discharge executed by the discharge circuit can be suppressed.

In accordance with a second aspect, in the battery control monitoring system according to the first aspect, the fixation monitoring circuit is electrically connected to the controller to input a fixation monitoring signal indicating a state of the discharge circuit. The controller is configured to determine the signal fixation based on the fixation monitoring signal.

With the battery control monitoring system according to the second aspect, since the signal fixation can be determined based on the fixation monitoring signal, it is possible to determine the signal fixation with a simple configuration.

In accordance with a third aspect, in the battery control monitoring system according to the second aspect, the controller is configured to determine the signal fixation by comparing the fixation monitoring signal with a reference signal pattern.

With the battery control monitoring system according to the third aspect, the accuracy of determining the signal fixation can be improved by comparing the fixation monitoring signal with the reference signal pattern.

In accordance with a fourth aspect, in the battery control monitoring system according to the third aspect, the control signal includes a first control signal. The controller is configured to output the first control signal to the discharge circuit. The discharge circuit is configured to execute the forced discharge based on the first control signal. The reference signal pattern includes a pattern of the fixation monitoring signal in a case where the first control signal is not fixed.

With the battery control monitoring system according to the fourth aspect, since the reference signal pattern includes the pattern of the fixation monitoring signal in the state where the first control signal is not fixed, the accuracy of determining the signal fixation can be reliably improved by comparing the fixation monitoring signal with the reference signal pattern.

In accordance with a fifth aspect, in the battery control monitoring system according to the third or fourth aspect, the control signal includes a power signal different from the first control signal. The controller is configured to output the power signal to the discharge circuit. The discharge circuit is configured to execute forced discharge based on the first control signal and the power signal. The reference signal pattern includes a pattern of the fixation monitoring signal in a state where the power signal is not fixed.

With the battery control monitoring system according to the fifth aspect, since the reference signal pattern includes the pattern of the fixation monitoring signal in the state where the power signal is not fixed, the accuracy of determining the signal fixation can be reliably improved by comparing the fixation monitoring signal with the reference signal pattern.

In accordance with a sixth aspect, in the battery control monitoring system according to the fifth aspect, the discharge circuit includes a first switch circuit electrically connected to the controller and a second switch circuit electrically connected to the first switch circuit. The second switch circuit has a connection state in which a positive terminal of the rechargeable battery and a negative terminal of the rechargeable battery are electrically connected and a cut-off state in which an electrical connection between the positive terminal of the rechargeable battery and the negative terminal of the rechargeable battery is cut off. The first switch circuit is configured to output a second control signal based on the first control signal and the power signal. The second switch circuit is configured to switch between the connection state and the cut-off state based on the second control signal.

With the battery control monitoring system according to the sixth aspect, the configuration of the discharge circuit can be comparatively simplified by using the first switch circuit and the second switch circuit.

In accordance with a seventh aspect, in the battery control monitoring system according to the sixth aspect, the fixation monitoring circuit is electrically connected to a connection portion of the first switch circuit and the second switch circuit to input the second control signal to the controller as the fixation monitoring signal.

With the battery control monitoring system according to the seventh aspect, the signal fixation can be reliably determined by using the second control signal as the fixation monitoring signal.

In accordance with an eighth aspect, in the battery control monitoring system according to the sixth or seventh aspect, the first switch circuit includes a first field effect transistor. The first field effect transistor includes a first gate, a first source, and a first drain. The controller is electrically connected to the first gate to supply the first control signal to the first gate. The controller is electrically connected to one of the first source and the first drain to supply the power signal to the one of the first source and the first drain. The other of the first source and the first drain is electrically connected to the second switch circuit. The first field effect transistor is configured to switch, based on the first control signal supplied to the first gate, between a first conduction state in which electrical conduction is allowed between the first source and the first drain and a first cut-off state in which electrical conduction is cut off between the first source and the first drain.

With the battery control monitoring system according to the eighth aspect, since the first switch circuit includes the first field effect transistor, at least one of improved switching speed and reduced power consumption of the discharge circuit can be achieved.

In accordance with a ninth aspect, in the battery control monitoring system according to the eighth aspect, the second switch circuit includes a second field effect transistor. The second field effect transistor includes a second gate, a second source, and a second drain. The second gate is connected to one of the first source and the first drain to receive the second control signal from the first switch circuit. One of the second source and the second drain is configured to be electrically connected to the rechargeable battery.

With the battery control monitoring system according to the ninth aspect, since the second switch circuit includes the second field effect transistor, at least one of improved switching speed and reduced power consumption of the discharge circuit can be achieved.

In accordance with a tenth aspect, in the battery control monitoring system according to the sixth or seventh aspect, the first switch circuit includes a first bipolar transistor. The first bipolar transistor includes a first base, a first collector, and a first emitter. The controller is electrically connected to the first base to supply the first control signal to the first base. The controller is electrically connected to one of the first collector and the first emitter to supply the power signal to the one of the first collector and the first emitter. The other of the first collector and the first emitter is electrically connected to the second switch circuit. the first bipolar transistor is configured to switch, based on the first control signal supplied to the first base, between a first conduction state in which electrical conduction is allowed between the first collector and the first emitter and a first cut-off state in which electrical conduction is cut off between the first collector and the first emitter.

With the battery control monitoring system according to the tenth aspect, since the first switch circuit includes the first bipolar transistor, current can be efficiently amplified, and the power consumption of the discharge circuit can be reduced.

In accordance with an eleventh aspect, in the battery control monitoring system according to the tenth aspect, the second switch circuit includes a second bipolar transistor. The second bipolar transistor includes a second base, a second collector, and a second emitter. The second base is connected to one of the first collector and the first emitter to receive the second control signal from the first switch circuit. One of the second collector and the second emitter is configured to be electrically connected to the rechargeable battery.

With the battery control monitoring system according to the eleventh aspect, since the second switch circuit includes the second bipolar transistor, current can be efficiently amplified, and the power consumption of the discharge circuit can be reduced.

In accordance with a twelfth aspect, in the battery control monitoring system according to any one of the fifth to eleventh aspects, the discharge circuit includes a protective resistor connecting a line of the first control signal and a line of the power signal.

With the battery control monitoring system according to the twelfth aspect, since the discharge circuit includes the protective resistor, the power signal is input to the discharge circuit when the power of the controller is activated, and it is possible to prevent the first control signal from being unintentionally input to the discharge circuit due to the input of the power signal in a state where the first control signal is not input. Therefore, unintended operation of the discharge circuit can be prevented when the power of the controller is activated.

In accordance with a thirteenth aspect, in the battery control monitoring system according to any one of the first to twelfth aspects, the fixation monitoring circuit includes a fixation detection resistor electrically connected to the discharge circuit and the controller.

With the battery control monitoring system according to the thirteenth aspect, since the fixation monitoring circuit includes the fixation detection resistor, the configuration of the fixation monitoring circuit can be simplified.

In accordance with a fourteenth aspect, in the battery control monitoring system according to any one of the first to thirteenth aspects, the controller is configured to determine over-current in a case where a current value of the rechargeable battery exceeds a current threshold during the forced discharge.

With the battery control monitoring system according to the fourteenth aspect, over-current can be detected during the forced discharge.

In accordance with a fifteenth aspect, in the battery control monitoring system according to any one of the first to fourteenth aspects, the controller is configured to calculate an estimated elevated temperature of the rechargeable battery based on the current value of the rechargeable battery.

With the battery control monitoring system according to the fifteenth aspect, the estimated elevated temperature of the rechargeable battery can be calculated without using a temperature sensor, allowing for the detection of overheating of the rechargeable battery with a simple configuration.

In accordance with a sixteenth aspect, the battery control monitoring system according to any one of the first to fifteenth aspects further comprises a forced shutdown circuit configured to forcibly terminate the forced discharge executed by the discharge circuit in a case where the signal fixation occurs.

With the battery control monitoring system according to the sixteenth aspect, since the forced discharge executed by the discharge circuit is forcibly terminated by the forced shutdown circuit in the case where the signal fixation occurs, the reduction in the accuracy of arithmetic processing using the forced discharge executed by the discharge circuit can be reliably suppressed.

In accordance with a seventeenth aspect, the battery control monitoring system according to any one of the first to sixteenth aspects further comprises a main device and an external device configured to communicate with the main device. The main device includes a controller, a fixation monitoring circuit, and a communication circuit configured to communicate with the external device. The controller is configured to transmit a fixation determination result indicating occurrence of the signal fixation to the external device via the communication circuit in a case where the signal fixation occurs.

With the battery control monitoring system according to the seventeenth aspect, for example, the transmission of the fixation determination result to the external device enables a user of the battery control monitoring system who is at a location remote from the main device to be notified of the fixation determination result.

In accordance with an eighteenth aspect, a battery control monitoring device comprises a discharge circuit, a controller, and a fixation monitoring circuit. The discharge circuit is configured to execute forced discharge of a rechargeable battery. The controller is electrically connected to the discharge circuit and is configured to control the forced discharge executed by the discharge circuit using a control signal. The fixation monitoring circuit is electrically connected to the controller and is configured to monitor the signal fixation.

With the battery control monitoring device according to the eighteenth aspect, since the signal fixation can be monitored using the fixation monitoring circuit, a malfunction of at least one of the discharge circuit and the controller can be detected. Accordingly, the reduction in the accuracy of arithmetic processing using the forced discharge executed by the discharge circuit can be suppressed.

In accordance with a nineteenth aspect, a battery control monitoring method comprises: controlling a discharge circuit using a control signal to execute forced discharge of a rechargeable battery by a controller; and monitoring signal fixation by a fixation monitoring circuit.

With the battery control monitoring method according to the nineteenth aspect, since the signal fixation can be monitored using the fixation monitoring circuit, a malfunction of at least one of the discharge circuit and the controller can be detected. Accordingly, the reduction in the accuracy of arithmetic processing using the forced discharge executed by the discharge circuit can be suppressed.

In accordance with a twentieth aspect, a battery control monitoring program causes a computer to execute the battery control monitoring method according to the nineteenth aspect.

With the battery control monitoring program according to the twentieth aspect, by causing the computer to execute the battery control monitoring method, it is possible to suppress the reduction in the accuracy of arithmetic processing using the forced discharge executed by the discharge circuit.

In accordance with a twenty-first aspect, a computer-readable storage medium stores the battery control monitoring program according to the twentieth aspect.

With the storage medium according to the twenty-first aspect, by causing he computer to execute the battery control monitoring method, it is possible to suppress the reduction in the accuracy of arithmetic processing using the forced discharge executed by the discharge circuit.

Advantageous Effects of Invention

The technology disclosed in the present application can provide, for example, the battery control monitoring system, the battery control monitoring device, the battery control monitoring method, the battery control monitoring program, and the storage medium that can suppress the reduction in the accuracy of arithmetic processing using the forced discharge executed by the discharge circuit.

The technology disclosed in the present application can provide, for example, the battery control monitoring system, the battery control monitoring device, the battery control monitoring method, the battery control monitoring program, and the storage medium that can detect in advance the occurrence of the malfunction caused by the signal fixation.

Brief Description of Drawings

FIG. 1 is a schematic block diagram of a battery control monitoring system.

FIG. 2 is a schematic diagram showing signal patterns of a controller, a discharge circuit, and a fixation monitoring circuit of the battery control monitoring system shown in FIG. 1.

FIG. 3 is a schematic block diagram of the controller and the discharge circuit of the battery control monitoring system shown in FIG. 1.

FIG. 4 is a schematic diagram showing the signal patterns of the controller, the discharge circuit, and the fixation monitoring circuit of the battery control monitoring system shown in FIG. 1 (in a case where the first control signal is fixed).

FIG. 5 is a schematic diagram showing the signal patterns of the controller, the discharge circuit, and the fixation monitoring circuit of the battery control monitoring system shown in FIG. 1 (in a case where the first control signal cannot be controlled).

FIG. 6 is a schematic diagram showing the signal patterns of the controller, the discharge circuit, and the fixation monitoring circuit of the battery control monitoring system shown in FIG. 1 (in the case where the first control signal is fixed).

FIG. 7 is a schematic diagram showing the signal patterns of the controller, the discharge circuit, and the fixation monitoring circuit of the battery control monitoring system shown in FIG. 1 (in a case where the power signal is fixed).

FIG. 8 is a schematic diagram showing the signal patterns of the controller, the discharge circuit, and the fixation monitoring circuit of the battery control monitoring system shown in FIG. 1 (in the case where the power signal is fixed).

FIG. 9 is a schematic block diagram showing the exchange of information in the battery control monitoring system shown in FIG. 1.

FIG. 10 is a flowchart showing a battery control monitoring method executed in the battery control monitoring system shown in FIG. 1.

FIG. 11 is a flowchart showing the battery control monitoring method executed in the battery control monitoring system shown in FIG. 1.

FIG. 12 is a flowchart showing the battery control monitoring method executed in the battery control monitoring system shown in FIG. 1.

FIG. 13 is a flowchart showing the battery control monitoring method executed in the battery control monitoring system shown in FIG. 1.

FIG. 14 is a schematic block diagram of the controller and the discharge circuit in accordance with a modification of the battery control monitoring system.

FIG. 15 is a schematic block diagram of the controller and the discharge circuit in accordance with a modification of the battery control monitoring system.

FIG. 16 is a flowchart showing a modification of the battery control monitoring method executed in the battery control monitoring system.

Description of Embodiments

Embodiments will be described below with reference to the drawings. In the drawings, the same reference signs indicate corresponding or identical configurations.

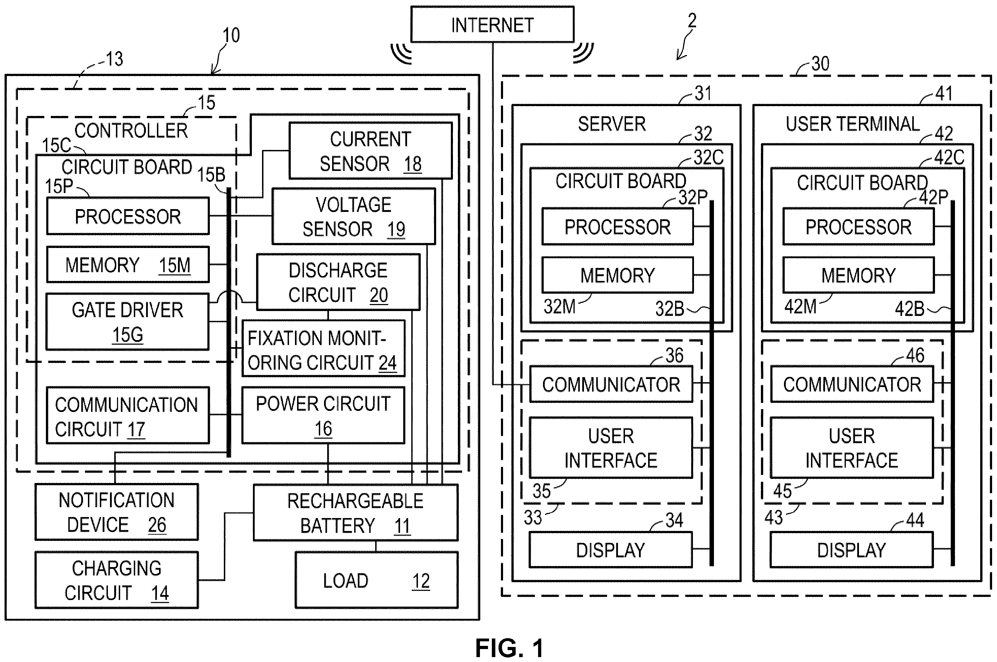

As shown in FIG. 1, a battery control monitoring system 2 comprises a main device 10 and an external device 30 configured to communicate with the main device 10. The main device 10 includes a rechargeable battery 11 and a load 12 electrically connected to the rechargeable battery 11. Examples of the main device 10 include a vehicle equipped with the rechargeable battery 11. The rechargeable battery 11 is electrically connected to the load 12 to supply power to the load 12. The rechargeable battery 11 includes a secondary battery such as a lead-acid battery, a lithium-ion battery, and a nickel-metal hydride battery. Therefore, the rechargeable battery 11 may also be referred to as a secondary battery 11.

The load 12 operates on the electricity supplied from the rechargeable battery 11. The load 12 includes at least one electrical device. In a case where the rechargeable battery 11 is mounted on a vehicle, examples of the electrical device include an electronic control unit (ECU), a light, a heater, an audio device, a sensor, and a camera.

Examples of the vehicle include an automobile. Examples of an automobile include a vehicle equipped with an engine (internal combustion engine) as a power source, a hybrid vehicle equipped with an engine and a vehicle drive motor as power sources, and an electric vehicle or fuel cell vehicle equipped with a vehicle drive motor as a power source. Therefore, for instance, the rechargeable battery 11 may be used for driving the vehicle, or a vehicle drive battery other than the rechargeable battery 11 may be mounted on the vehicle. The vehicle is not limited to the above examples. Additionally, the rechargeable battery 11 may be used for applications other than vehicles.

The main device 10 includes a battery control monitoring device 13. Namely, the battery control monitoring system 2 includes the battery control monitoring device 13. The battery control monitoring device 13 is configured to determine a state of the rechargeable battery 11. Specifically, the battery control monitoring device 13 is configured to calculate the full charge capacity of the rechargeable battery 11. The main device 10 is configured to communicate with the external device 30 via the internet. The battery control monitoring device 13 is configured to communicate with the external device 30 via the internet.

The external device 30 includes, for example, a server 31 and a user terminal 41. The server 31 is connectable to the internet. The battery control monitoring device 13 and the user terminal 41 are connectable to the server 31 via the internet. The battery control monitoring device 13 is configured to communicate with the server 31 via the internet. The user terminal 41 is configured to communicate with the server 31 via the internet. The battery control monitoring device 13 may be configured to communicate directly with the user terminal 41 via the internet. Examples of the user terminal 41 include a smartphone, a tablet computer, and a personal computer.

The main device 10 includes a charging circuit 14. The rechargeable battery 11 is electrically connected to the charging circuit 14. The charging circuit 14 supplies electricity to the rechargeable battery 11 and charges the rechargeable battery 11. In the case where the rechargeable battery 11 is mounted on the vehicle, for example, the charging circuit 14 includes a power generation device such as an alternator and a vehicle drive motor.

The load 12 starts operation using the electricity supplied from the rechargeable battery 11. For example, when the start button of the vehicle is pressed or the start key is turned, the supply of electricity from the rechargeable battery 11 to the load 12 begins, and the load 12 starts operation.

The battery control monitoring device 13 comprises a controller 15. Namely, the battery control monitoring system 2 comprises the controller 15. In the present embodiment, since the main device 10 includes the battery control monitoring device 13, the main device 10 includes the controller 15. However, the external device 30 (e.g., the server 31) may include the entire controller 15. The main device 10 includes a part of the controller 15. The external device 30 may include the remaining part of the controller 15. Similarly, the external device 30 may include the entirety of the battery control monitoring device 13. The main device 10 includes a part of the battery control monitoring device 13. The external device 30 may include the remaining part of the battery control monitoring device 13.

In the present embodiment, the controller 15 is connected to the rechargeable battery 11. The controller 15 includes, for example, a processor 15P, a memory 15M, a circuit board 15C, and a bus 15B.

The processor 15P includes, for example, a CPU (Central Processing Unit) and/or an MPU (Micro Processing Unit). The memory 15M includes, for example, a volatile memory and a non-volatile memory. Examples of the volatile memory include a RAM (Random Access Memory) and/or a DRAM (Dynamic Random Access Memory). Examples of the non-volatile memory include a ROM (Read Only Memory) and an EEPROM (Electrically Erasable Programmable ROM). The memory 15M may also be referred to as a computer-readable storage medium. The processor 15P and the memory 15M are electrically mounted on the circuit board 15C. The processor 15P and the memory 15M are electrically connected to each other via the circuit board 15C. The processor 15P may also be referred to as a hardware processor 15P. The memory 15M may also be referred to as a hardware memory 15M.

The controller 15 is programmed to implement control algorithms for the battery control monitoring system 2 and the battery control monitoring device 13. The memory 15M of the controller 15 stores software, such as programs for implementing the control algorithms of the battery control monitoring device 13. The processor 15P executes the programs stored in the memory 15M to implement the control algorithms of the battery control monitoring device 13.

The configuration of the controller 15 is not limited to the processor 15P, the memory 15M, the circuit board 15C, and the bus 15B. The configuration of the controller 15 can be realized with hardware alone or a combination of hardware and software. Additionally, the processor 15P and the memory 15M may be configured in a single chip such as an ASIC (Application Specific Integrated Circuit) or an FPGA (Field Programmable Gate Array). Furthermore, the controller 15 may also be referred to as a controller circuit 15, controller circuitry 15, circuit 15, and/or circuitry 15.

The controller 15 is electrically connected to the rechargeable battery 11. The battery control monitoring device 13 includes a power circuit 16. The power circuit 16 is electrically connected to the controller 15 and the rechargeable battery 11. The power circuit 16 is provided between the controller 15 and the rechargeable battery 11. The power circuit 16 converts the voltage supplied from the rechargeable battery 11 (e.g., 12V) to a predetermined voltage (e.g., 3.3V or 5V) as necessary. The controller 15 operates using the electricity supplied from the rechargeable battery 11 through the power circuit 16. The power circuit 16 is electrically connected to the processor 15P and the memory 15M via the circuit board 15C and the bus 15B.

As shown in FIG. 1, the battery control monitoring device 13 includes a communication circuit 17. Namely, the battery control monitoring system 2 includes the communication circuit 17. The main device 10 includes the communication circuit 17. The communication circuit 17 is configured to communicate with the external device 30. The communication circuit 17 is electrically connected to the controller 15.

The communication circuit 17 is configured to transmit a fixation determination result DR1 to at least one of the server 31 and the user terminal 41. The communication circuit 17 is electrically connected to the processor 15P and the memory 15M via the circuit board 15C and the bus 15B. The communication circuit 17 operates using the electricity supplied from the controller 15.

The communication circuit 17 includes a wireless communication circuit. The wireless communication circuit is electrically connected to the controller 15. For example, it is wirelessly connectable to the internet. The wireless communication circuit is configured to transmit the fixation determination result DR1 (for example, full charge capacity, capacity determination result) to the server 31 via the internet. When the rechargeable battery 11 is mounted in a vehicle, the communication circuit 17 includes, for example, a wireless communication circuit and a gateway ECU.

The wireless communication circuit includes, for example, an antenna, a wireless transmitting circuit, and a wireless receiving circuit. The antenna is electrically connected to the wireless transmitting circuit and the wireless receiving circuit. The wireless transmitting circuit is configured to transmit signals wirelessly via the antenna. The wireless receiving circuit is configured to receive signals wirelessly via the antenna. The wireless transmitting circuit is configured to encrypt signals with a predetermined protocol. The wireless receiving circuit is configured to decrypt wireless signals with a predetermined protocol. The communication circuit 17 may also be configured to communicate with the server 31 via wired communication.

As shown in FIG. 1, the server 31, for example, constitutes a part of a data center or cloud and is connectable to the internet. The server 31 comprises a controller 32, an interface 33, and a display 34. The interface 33 and the display 34 are electrically connected to the controller 32. The display 34 is electrically connected to the controller 32 and is configured to display information. The controller 32 is configured to control the display 34 to display information.

The controller 32 includes, for example, a processor 32P, a memory 32M, a circuit board 32C, and a bus 32B. The processor 32P includes, for example, a CPU and/or an MPU. The memory 32M includes, for example, a volatile memory and a non-volatile memory. Examples of the volatile memory include a RAM and/or a DRAM. Examples of the non-volatile memory include a ROM and an EEPROM. The memory 32M may also be referred to as a computer-readable storage medium. The processor 32P and the memory 32M are electrically mounted on the circuit board 32C. The processor 32P and the memory 32M are electrically connected to each other via the circuit board 32C. The processor 32P may also be referred to as a hardware processor 32P. The memory 32M may also be referred to as a hardware memory 32M.

The controller 32 is programmed to implement the control algorithms of the server 31. The memory 32M of the controller 32 stores software, such as programs for implementing the control algorithms of the server 31. The processor 32P executes the programs stored in the memory 32M to implement the control algorithms of the server 31.

The configuration of the controller 32 is not limited to the processor 32P, the memory 32M, the circuit board 32C, and the bus 32B. The configuration of the controller 32 can be realized with hardware alone or a combination of hardware and software. Additionally, the processor 32P and the memory 32M may be configured in a single chip such as an ASIC or an FPGA. Furthermore, the controller 32 may also be referred to as a controller circuit 32, controller circuitry 32, a circuit 32, and/or circuitry 32.

The interface 33 is electrically connected to the processor 32P and the memory 32M via the circuit board 32C and the bus 32B. The interface 33 includes a user interface 35 and a communicator 36.

The user interface 35 is electrically connected to the controller 32. The user interface 35 is electrically connected to the processor 32P and the memory 32M via the circuit board 32C and the bus 32B. The user interface 35 is used by a user to operate the server 31. Examples of the user interface 35 include a keyboard, a mouse, and a touch panel.

The communicator 36 is electrically connected to the controller 32. The communicator 36 is electrically connected to the processor 32P and the memory 32M via the circuit board 32C and the bus 32B. The communicator 36 is configured to communicate with the battery control monitoring device 13 and the user terminal 41.

The communicator 36 includes, for example, a wired communication circuit. The wired communication circuit is electrically connected to the controller 32. For example, it is possible to connect to the internet via a wired connection. The wired communication circuit is configured to communicate with the battery control monitoring device 13 and the user terminal 41 via the internet. The communicator 36 may also include a wireless communication circuit.

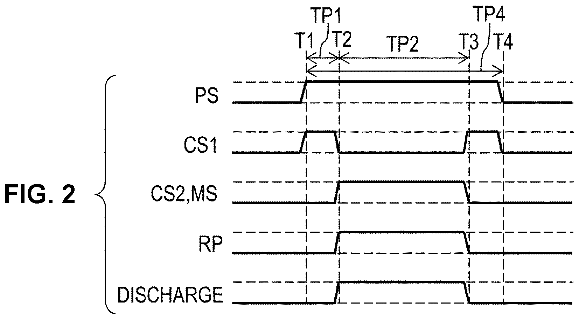

As shown in FIG. 2, the communicator 36 is configured to receive the fixation determination result DR1 from the battery control monitoring device 13. The communicator 36 is configured to transmit the fixation determination result DR1 received from the battery control monitoring device 13 to the user terminal 41. The communicator 36 is configured to receive input information from the user terminal 41. The communicator 36 is configured to transmit the input information received from the user terminal 41 to the battery control monitoring device 13.

As shown in FIG. 1, the user terminal 41 is configured to communicate with the server 31. The user terminal 41 is a device used by a user of the battery control monitoring system 2. The user terminal 41 is configured to display the fixation determination result DR1 (for example, the fixation determination result DR1) transmitted from the server 31. Additionally, the user terminal 41 is configured to receive the input information necessary for battery control monitoring from the user of the battery control monitoring system 2. It is configured to transmit the input information to the server 31. Examples of the user terminal 41 include a smartphone, a tablet computer, and a personal computer.

The user terminal 41 comprises a controller 42, an interface 43, and a display 44. The interface 43 and the display 44 are electrically connected to the controller 42. The display 44 is electrically connected to the controller 42. It is configured to display information. The controller 42 is configured to control the display 44 to display the information.

The controller 42 includes, for example, a processor 42P, a memory 42M, a circuit board 42C, and a bus 42B. The processor 42P includes, for example, a CPU and/or an MPU. The memory 42M includes, for example, a volatile memory and a non-volatile memory. Examples of the volatile memory include a RAM and/or a DRAM. Examples of the non-volatile memory include a ROM and an EEPROM. The memory 42M may also be referred to as a computer-readable storage medium. The processor 42P and the memory 42M are electrically mounted on the circuit board 42C. The processor 42P and the memory 42M are electrically connected to each other via the circuit board 42C. The processor 42P may also be referred to as a hardware processor 42P. The memory 42M may also be referred to as a hardware memory 42M.

The controller 42 is programmed to implement the control algorithms of the user terminal 41. The memory 42M of the controller 42 stores software, such as programs for implementing the control algorithms of the user terminal 41. The processor 42P executes the programs stored in the memory 42M to implement the control algorithms of the user terminal 41.

The configuration of the controller 42 is not limited to the processor 42P, the memory 42M, the circuit board 42C, and the bus 42B. The configuration of the controller 42 can be realized with hardware alone or a combination of hardware and software. Additionally, the processor 42P and the memory 42M may be configured in a single chip such as an ASIC or an FPGA. Furthermore, the controller 42 may also be referred to as a controller circuit 42, controller circuitry 42, a circuit 42, and/or circuitry 42.

The interface 43 is electrically connected to the processor 42P and the memory 42M via the circuit board 42C and the bus 42B. The interface 43 includes a user interface 45 and a communicator 46.

The user interface 45 is electrically connected to the controller 42. The user interface 45 is electrically connected to the processor 42P and the memory 42M via the circuit board 42C and the bus 42B. The user interface 45 is configured to receive input information from a user. The controller 42 stores the input information received from the user interface 45 in the memory 42M. Examples of the user interface 45 include a keyboard, a mouse, and a touch panel.

The communicator 46 is electrically connected to the controller 42. The communicator 46 is electrically connected to the processor 42P and the memory 42M via the circuit board 42C and the bus 42B. The communicator 46 is configured to communicate with the server 31. The communicator 46 includes a wireless communication circuit. The wireless communication circuit is electrically connected to the controller 42. It is configured to communicate wirelessly with the server 31 via the internet. The communicator 46 may also include a wired communication circuit.

Similar to the communication circuit 17, the wireless communication circuit of the communicator 46 includes, for example, an antenna, a wireless transmitting circuit, and a wireless receiving circuit. The antenna is electrically connected to the wireless transmitting circuit and the wireless receiving circuit. The wireless transmitting circuit is configured to transmit signals wirelessly via the antenna. The wireless receiving circuit is configured to receive signals wirelessly via the antenna. The wireless transmitting circuit is configured to encrypt signals with a predetermined protocol. The wireless receiving circuit is configured to decrypt wireless signals with a predetermined protocol.

As shown in FIG. 2, the communicator 46 is configured to transmit the input information to the server 31 via the internet. The communicator 46 is configured to receive the fixation determination result DR1 transmitted from the server 31 via the internet.

As shown in FIG. 1, the battery control monitoring system 2 comprises a current sensor 18 and a voltage sensor 19. The main device 10 comprises a current sensor 18 and a voltage sensor 19. In the present embodiment, the battery control monitoring device 13 comprises a current sensor 18 and a voltage sensor 19. However, at least one of the current sensor 18 and the voltage sensor 19 may be provided outside the battery control monitoring device 13 and within the main device 10.

The current sensor 18 is electrically connected to the controller 15. The current sensor 18 is configured to measure the current value of the rechargeable battery 11. The voltage sensor 19 is electrically connected to the controller 15. The voltage sensor 19 is configured to measure the voltage value of the rechargeable battery 11.

The current sensor 18 is disposed between the rechargeable battery 11 and the load 12 and between the rechargeable battery 11 and the charging circuit 14. The current sensor 18 is configured to measure the current value of the discharge current value flowing from the rechargeable battery 11 to the load 12. It is configured to measure the charging current value flowing from the charging circuit 14 to the rechargeable battery 11. The controller 15 obtains the measured current values from the current sensor 18 in a predetermined cycle and stores the obtained measured current values in the memory 15M. Additionally, the controller 15 is configured to calculate the accumulated value of the measured current values as necessary.

The controller 15 is configured to determine, based on the measured current values of the current sensor 18, whether the rechargeable battery 11 is discharging or whether the rechargeable battery 11 is charging. Namely, the controller 15 is configured to determine, based on the measured current values and the measured voltage values, whether the rechargeable battery 11 is in a state where charging and discharging are being stopped. In a case where the rechargeable battery 11 is in the state where charging and discharging are being stopped, the supply of electricity to the load 12 stops except for dark current. Therefore, the controller 15 is configured to determine whether the load 12 is stopped based on the measured current values and the measured voltage values. In the case where the rechargeable battery 11 is in the state where charging and discharging are being stopped, for example, a start switch or a start key of the vehicle is off. Therefore, the controller 15 is configured to determine whether the start switch or the start key of the vehicle is off. Additionally, the case where the rechargeable battery 11 is in the state where charging and discharging are being stopped can also be referred to as a case where the main device 10 (for example, the vehicle) is being stopped.

The controller 15 is configured to calculate the internal resistance value of the rechargeable battery 11. The controller 15 is configured, for example, to estimate the state (SOC (State of Charge), SOH (State of Health), SOF (State of Function), full charge capacity) of the rechargeable battery 11 using the internal resistance value.

In the present embodiment, the controller 15 is configured to calculate the internal resistance value R of the rechargeable battery 11. The controller 15 is configured, for example, to calculate the internal resistance value R of the rechargeable battery 11 based on the current value and the voltage value of the rechargeable battery 11 obtained while charging and discharging are being stopped. The controller 15 is configured, for example, to calculate the internal resistance value R based on the measured current value of the current sensor 18 and the measured voltage value of the voltage sensor 19 obtained while charging is being stopped. However, another device mounted on the main device 10 or the external device 30 (for example, the server 31) may be configured to calculate the internal resistance value R. Additionally, the controller 15 may be configured to calculate the internal resistance value R of the rechargeable battery 11 based on the current value and the voltage value of the rechargeable battery 11 regardless of while charging and discharging are being stopped. The controller 15 may be configured to calculate the internal resistance value R based on the measured current value of the current sensor 18 and the measured voltage value of the voltage sensor 19 at a timing other than while charging is being stopped.

The battery control monitoring system 2 comprises a discharge circuit 20. The discharge circuit 20 is configured to execute forced discharge of the rechargeable battery 11. The controller 15 is electrically connected to the discharge circuit 20 and is configured to control the forced discharge executed by the discharge circuit 20 using a control signal CS. The controller 15 is configured, for example, to calculate the internal resistance value R based on the current value and the voltage value of the rechargeable battery 11 in a case where the discharge circuit 20 executes the forced discharge of the rechargeable battery 11 while charging and discharging are being stopped. However, the forced discharge executed by the discharge circuit 20 may be used for other purposes. The controller 15 may be configured to calculate the internal resistance value R based on the current value and the voltage value of the rechargeable battery 11 in a case where the discharge circuit 20 executes the forced discharge of the rechargeable battery 11 regardless of while charging and discharging are being stopped.

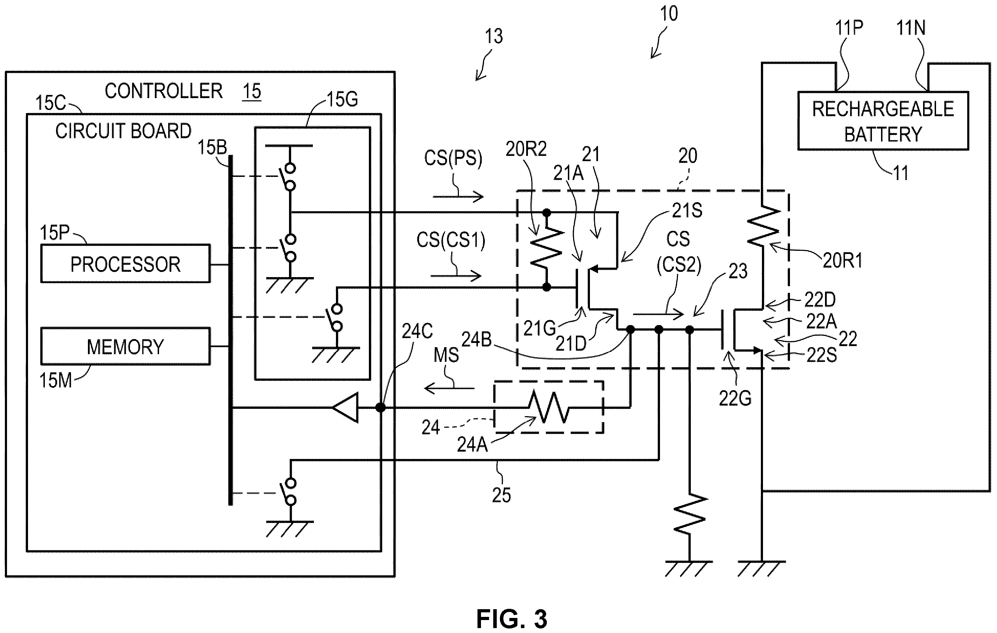

As shown in FIG. 3, the discharge circuit 20 includes a first switch circuit 21 electrically connected to the controller 15 and a second switch circuit 22 electrically connected to the first switch circuit 21. The second switch circuit 22 has a connection state in which the positive terminal 11P of the rechargeable battery 11 and the negative terminal 11N of the rechargeable battery 11 are electrically connected and a cut-off state in which an electrical connection between the positive terminal 11P and the negative terminal 11N of the rechargeable battery 11 is cut off. The first switch circuit 21 is electrically connected to the second switch circuit 22 to control the operation of the second switch circuit 22. The first switch circuit 21 is configured to switch the state of the second switch circuit 22 between the connection state and the cut-off state based on the control of the controller 15.

The discharge circuit 20 includes a resistor 20R1. The resistor 20R1 is provided between the positive terminal 11P of the rechargeable battery 11 and the second switch circuit 22. The resistor 20R1 defines the current value for forced discharge.

The discharge circuit 20 includes a protective resistor 20R2 connecting a line of the first control signal CS1 and a line of the power signal PS. Specifically, the protective resistor 20R2 is disposed between the first gate 21G and the first source S to connect the first gate 21G and the first source S.

The control signal CS includes the first control signal CS1. The controller 15 is configured to output the first control signal CS1 to the discharge circuit 20. The discharge circuit 20 is configured to execute the forced discharge based on the first control signal CS1. The first switch circuit 21 is configured to switch the state of the second switch circuit 22 between the connection state and the cut-off state based on the first control signal CS1. In a case where the discharge circuit 20 executes pulse discharge, the controller 15 is configured to output the first control signal CS1 to the discharge circuit 20 in a predetermined cycle.

The control signal CS includes a power signal PS different from the first control signal CS1. The controller 15 is configured to output the power signal PS to the discharge circuit 20. The discharge circuit 20 is configured to execute the forced discharge based on the first control signal CS1 and the power signal PS. The first switch circuit 21 is configured to switch the state of the second switch circuit 22 between the connection state and the cut-off state based on the first control signal CS1 and the power signal PS. The first switch circuit 21 is configured to output a second control signal CS2 based on the first control signal CS1 and the power signal PS. The second switch circuit 22 is configured to switch to one of the connection state and the cut-off state based on the second control signal CS2.

In the present embodiment, the first switch circuit 21 includes a first field effect transistor 21A. The second switch circuit 22 includes a second field effect transistor 22A. In the present embodiment, the first field effect transistor 21A (FET) includes a metal-oxide-semiconductor field-effect transistor (MOSFET). The second field effect transistor 22A includes a MOSFET. For example, the first field effect transistor 21A includes a P-channel MOSFET. The second field effect transistor 22A includes an N-channel MOSFET. However, the first field effect transistor 21A may include an N-channel MOSFET. The second field effect transistor 22A may include a P-channel MOSFET. The first field effect transistor 21A may include an FET other than a MOSFET. The second field effect transistor 22A may include an FET other than a MOSFET. Additionally, the first switch circuit 21 may include a circuit other than an FET. The second switch circuit 22 may include a circuit other than an FET.

The first field effect transistor 21A includes a first gate 21G, a first source 21S, and a first drain 21D.

The first gate 21G is electrically connected to the controller 15. One of the first source 21S and the first drain 21D is electrically connected to the controller 15. The other of the first source 21S and the first drain 21D is electrically connected to the second switch circuit 22. In the present embodiment, the first source 21S is electrically connected to the controller 15. The first drain 21D is electrically connected to the second switch circuit 22. In a case where the first field effect transistor 21A includes an N-channel MOSFET, however, the first drain 21D may be electrically connected to the controller 15, and the first source 21S may be electrically connected to the second switch circuit 22.

The second field effect transistor 22A includes a second gate 22G, a second source 22S, and a second drain 22D. The second gate 22G is electrically connected to the controller 15. One of the second source 22S and the second drain 22D is electrically connected to the first switch circuit 21. The other of the second source 22S and the second drain 22D is electrically connected to the rechargeable battery 11. In the present embodiment, the second drain 22D is electrically connected to the first switch circuit 21. The second source 22S is electrically connected to the rechargeable battery 11. In a case where the second field effect transistor 22A includes a P-channel MOSFET, however, the second source 22S may be electrically connected to the first switch circuit 21, and the second drain 22D may be electrically connected to the rechargeable battery 11.

As shown in FIG. 2, the first control signal CS1 indicates a change in voltage supplied from the controller 15 to the discharge circuit 20. For example, the first control signal CS1 indicates a change in the first gate voltage supplied from the controller 15 to the first gate 21G of the first switch circuit 21. In a state where the first gate voltage is supplied from the controller 15 to the first gate 21G of the first switch circuit 21, the first control signal CS1 is H (High). In a state where the first gate voltage is not supplied from the controller 15 to the first gate 21G of the first switch circuit 21, the first control signal CS1 is L (Low).

The power signal PS indicates a change in voltage supplied from the controller 15 to the discharge circuit 20. For example, the power signal PS indicates a change in power voltage supplied from the controller 15 to the first source 21S of the first switch circuit 21. In a state where the power voltage is supplied from the controller 15 to the first source 21S of the first switch circuit 21, the power signal PS is H (High). In a state where the power voltage is not supplied from the controller 15 to the first source 21S of the first switch circuit 21, the power signal PS is L (Low).

The second control signal CS2 indicates a change in voltage supplied from the first switch circuit 21 to the second switch circuit 22. For example, the second control signal CS2 indicates a change in the second gate voltage supplied from the first drain 21D of the first switch circuit 21 to the second gate 22G of the second switch circuit 22. In a state where the second gate voltage is supplied from the first switch circuit 21 to the second gate 22G of the second switch circuit 22, the second control signal CS2 is H (High). In a state where the second gate voltage is not supplied from the first switch circuit 21 to the second gate 22G of the second switch circuit 22, the second control signal CS2 is L (Low).

As shown in FIG. 3, the controller 15 is electrically connected to the first gate 21G to supply the first control signal CS1 to the first gate 21G. The controller 15 is electrically connected to one of the first source 21S and the first drain 21D to supply the power signal PS to the one of the first source 21S and the first drain 21D. The other of the first source 21S and the first drain 21D is electrically connected to the second switch circuit 22.

The first field effect transistor 21A is configured to switch, based on the first control signal CS1 supplied to the first gate 21G, between a first conduction state in which electrical conduction is allowed between the first source 21S and the first drain 21D and a first cut-off state in which electrical conduction is cut off between the first source 21S and the first drain 21D.

For example, the first field effect transistor 21A enters the first cut-off state in a state where the first gate voltage is not supplied between the first gate 21G and the first source 21S. In a case where the first field effect transistor 21A is in the first cut-off state, the power voltage supplied to the first source 21S is not supplied to the second switch circuit 22. On the other hand, the first field effect transistor 21A enters the first conduction state in a state where the first gate voltage is supplied between the first gate 21G and the first source 21S. In a case where the first field effect transistor 21A is in the first conduction state, the power voltage supplied to the first source 21S is supplied to the second switch circuit 22. The power voltage supplied to the second switch circuit 22 constitutes the second control signal CS2 and the second gate voltage.

The second gate 22G is connected to one of the first source 21S and the first drain 21D to receive the second control signal CS2 from the first switch circuit 21. One of the second source 22S and the second drain 22D is configured to be electrically connected to the rechargeable battery 11.

The second field effect transistor 22A is configured to switch, based on the second control signal CS2 supplied to the second gate 22G, between a second conduction state in which electrical conduction is allowed between the second source 22S and the second drain 22D and a second cut-off state in which electrical conduction is cut off between the second source 22S and the second drain 22D.

For example, the second field effect transistor 22A enters the second cut-off state in a state where the second gate voltage is not supplied between the second gate 22G and the second source 22S. In a case where the second field effect transistor 22A is in the second cut-off state, the positive terminal 11P of the rechargeable battery 11 is cut off from the negative terminal 11N of the rechargeable battery 11. On the other hand, the second field effect transistor 22A enters the second conduction state in a state where the second gate voltage is supplied between the second gate 22G and the second source 22S. In a state where the second field effect transistor 22A is in the second conduction state, the positive terminal 11P of the rechargeable battery 11 is electrically connected to the negative terminal 11N of the rechargeable battery 11. Therefore, the rechargeable battery 11 is discharged while the second field effect transistor 22A is in the second conduction state. As described above, the rechargeable battery 11 is discharged while the first gate voltage is supplied to the first switch circuit 21.

The controller 15 comprises a gate driver 15G. The gate driver 15G is electrically connected to the processor 15P and the memory 15M via the circuit board 15C and the bus 15B. The gate driver 15G is electrically connected to the discharge circuit 20. The discharge circuit 20 is electrically connected to the controller 15 via the gate driver 15G. The gate driver 15G is configured to control the operation of the discharge circuit 20.

As shown in FIG. 3, the gate driver 15G is configured to connect the first source 21S of the first switch circuit 21 to one of the ground and a driving power supply based on instructions from the processor 14P. In a state where the gate driver 15G connects the first source 21S to the ground, the power voltage is not supplied from the controller 15 to the first source 21S. On the other hand, in a state where the gate driver 15G connects the first source 21S to the driving power supply, the power voltage is supplied from the controller 15 to the first source 21S.

The gate driver 15G is configured to connect the first gate 21G of the first switch circuit 21 to the ground based on instructions from the processor 14P. The gate driver 15G is configured to cut the first gate 21G of the first switch circuit 21 off from the ground based on instructions from the processor 15P. In a state where the gate driver 15G cuts the first gate 21G off from the ground, the first gate voltage is not supplied from the controller 15 to the first gate 21G. In a state where the gate driver 15G connects the first source 21S to the driving power supply and where the gate driver 15G connects the first gate 21G to the ground, the first gate voltage, which is negative, is supplied to the first gate 21G.

As shown in FIG. 2, when the discharge operation of the discharge circuit 20 starts, the controller 15 supplies the power voltage to the first source 21S of the first switch circuit 21. Therefore, the power signal PS changes from L to H (see the timing T1 in FIG. 2). At this time, a voltage having substantially the same level as the power voltage is also supplied to the first gate 21G of the first switch circuit 21. Therefore, almost no potential difference arises between the first gate 21G and the first source 21S. Namely, when the power signal PS changes from L to H, the first control signal CS1 also changes from L to H (see the timing T1 in FIG. 2). Since almost no potential difference arises between the first gate 21G and the first source 21S, the first gate voltage is not supplied to the first gate 21G, and the first switch circuit 21 remains in the first cut-off state.

The controller 15 supplies the first gate voltage to the first gate 21G of the first switch circuit 21 after supplying the power voltage. For example, the controller 15 supplies the first gate voltage, which is negative based on the first source 21S as a reference, to the first gate 21G by connecting the first gate 21G to the ground. As a result, the first control signal CS1 changes from H to L (see the timing T2 in FIG. 2). When the first gate voltage, which is negative, is supplied to the first gate 21G, the first switch circuit 21 enters the first conduction state, and the power voltage supplied to the first source 21S is supplied as the second gate voltage to the second gate 22G of the second switch circuit 22. Namely, the second control signal CS2 changes from L to H (see the timing T2 in FIG. 2). Therefore, the second switch circuit 22 switches from the second cut-off state to the second conduction state, and the rechargeable battery 11 is discharged while the first gate voltage is supplied to the first switch circuit 21 (i.e., while the first control signal CS1 remains L).

The controller 15 stops supplying the first gate voltage to the first gate 21G of the first switch circuit 21 after a predetermined time has elapsed from the supply of the first gate voltage. As a result, the first control signal CS1 changes from L to H (see the timing T3 in FIG. 2). When the supply of the first gate voltage is stopped, the first switch circuit 21 enters the first cut-off state, and the first switch circuit 21 stops supplying the second gate voltage to the second gate 22G of the second switch circuit 22. At this time, the second control signal CS2 changes from L to H (see the timing T3 in FIG. 2). Since the supply of the second gate voltage is stopped, the second switch circuit 22 switches from the second conduction state to the second cut-off state, and the forced discharge of the rechargeable battery 11 is stopped.

The controller 15 calculates the internal resistance value R based on the measured current value of the current sensor 18 and the measured voltage value of the voltage sensor 19 before and during the supply of the first gate voltage.

The controller 15 is configured to obtain the current value A0 before discharging, the current value A1 during discharging, the voltage value V0 before discharging, and the voltage value V1 during discharging. The controller 15 is configured to calculate the internal resistance value R based on the following equation (1) using the current value A0, the current value A1, the voltage value V0, and the voltage value V1.

$$R = (V1\text{-}V0) / (A1\text{-}A0) \quad (1)$$

The controller 15 is configured to obtain the current value A0, the current value A1, the voltage value V0, and the voltage value V1 in a predetermined cycle and to calculate the internal resistance value R in a predetermined cycle based on the equation (1). The controller 15 stores the internal resistance value R in the memory 15M. The controller 15 calculates the internal resistance value R in a predetermined cycle during the stop of the load 12 and stores the internal resistance value R in the memory 15M. The internal resistance value R may be calculated by another method.

In the present embodiment, the discharge circuit 20 is configured to execute pulse discharge of the rechargeable battery 11 in a predetermined cycle. Specifically, the controller 15 is configured to discharge the rechargeable battery 11 in a predetermined cycle by supplying the first gate voltage to the first switch circuit 21 in a predetermined cycle. However, a mode of the forced discharge executed by the discharge circuit 20 is not limited to pulse discharge.

As described above, in the battery control monitoring system 2, the internal resistance value R is calculated by executing the forced discharge of the rechargeable battery 11 using the discharge circuit 20.

However, due to a malfunction of at least one of the controller 15 and the discharge circuit 20, the control signal CS may be fixed at H or L. When such signal fixation occurs, the forced discharge cannot be properly executed by the discharge circuit 20, resulting in the improper execution of processes which use the forced discharge or in decreased accuracy of processes which use the forced discharge (e.g., the internal resistance value R cannot be calculated or the accuracy of the internal resistance value R is decreased).

Therefore, as shown in FIG. 3, the battery control monitoring device 13 comprises a fixation monitoring circuit 24. Namely, the battery control monitoring system 2 comprises the fixation monitoring circuit 24. The main device 10 includes the fixation monitoring circuit 24. The fixation monitoring circuit 24 is electrically connected to the controller 15. The fixation monitoring circuit 24 is configured to monitor the signal fixation. In the present embodiment, the fixation monitoring circuit 24 is configured to monitor the signal fixation caused by a malfunction of at least one of the discharge circuit 20 and the controller 15. The fixation monitoring circuit 24 is configured to monitor the signal fixation caused by malfunctions of the discharge circuit 20 and the controller 15. However, the fixation monitoring circuit 24 may be configured to monitor the signal fixation caused by a malfunction of one of the discharge circuit 20 and the controller 15. The fixation monitoring circuit 24 may also be configured to monitor the signal fixation caused by factors other than the malfunctions of the discharge circuit 20 and the controller 15.

The fixation monitoring circuit 24 is electrically connected to the controller 15 to input a fixation monitoring signal MS indicating the state of the discharge circuit 20 to the controller 15. The controller 15 is configured to determine the signal fixation based on the fixation monitoring signal MS. For example, the controller 15 is configured to determine the signal fixation by comparing the fixation monitoring signal MS with a reference signal pattern RP. The controller 15 stores the reference signal pattern RP in the memory 15M.

The reference signal pattern RP includes the pattern of the fixation monitoring signal MS in a case where the first control signal CS1 is not fixed. The reference signal pattern RP includes the pattern of the fixation monitoring signal MS in a case where neither the first control signal CS1 nor the power signal PS is fixed.

The fixation monitoring circuit 24 is electrically connected to a connection portion 23 between the first switch circuit 21 and the second switch circuit 22 to input the second control signal CS2 to the controller 15 as the fixation monitoring signal MS. The fixation monitoring circuit 24 includes a fixation detection resistor 24A electrically connected to the discharge circuit 20 and the controller 15. The configuration of the fixation monitoring circuit 24 is not limited to the fixation detection resistor 24A. For example, the fixation monitoring circuit 24 may include configurations other than the fixation detection resistor 24A instead of or in addition to the fixation detection resistor 24A.

The fixation detection resistor 24A is connected to the connection portion 23 between the first switch circuit 21 and the second switch circuit 22. The fixation detection resistor 24A includes a first end portion 20B and a second end portion 20C. The first end portion 20B of the fixation detection resistor 24A is connected to the connection portion 23. The second end portion 20C of the fixation detection resistor 24A is connected to the controller 15. Thus, the second control signal CS2 which indicates the pattern of the second gate voltage supplied from the first switch circuit 21 to the second switch circuit 22 is input to the controller 15 as the fixation monitoring signal MS.

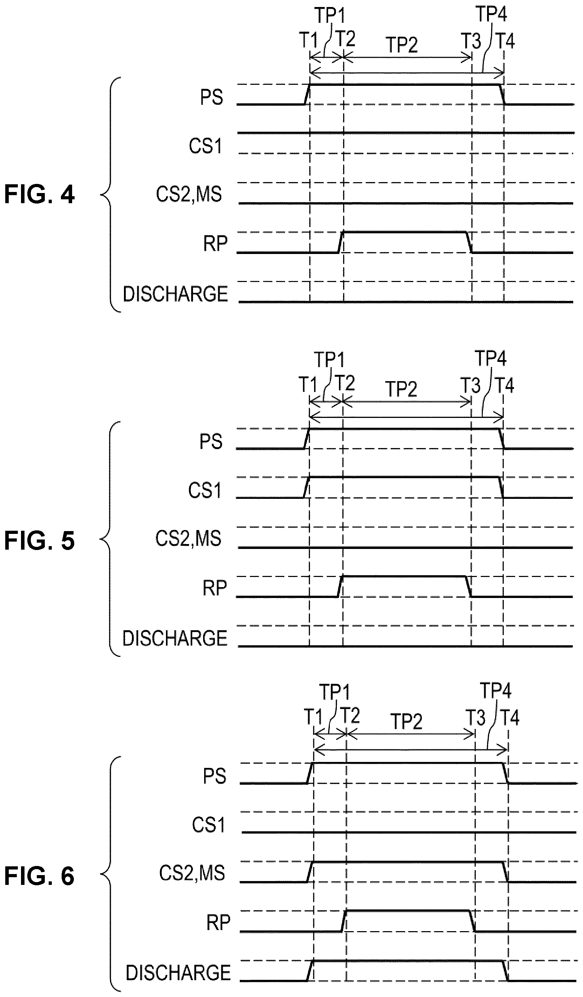

Here, the fixation patterns of the power signal PS and the first control signal CS1 will be described with reference to FIGS. 4 to 7.

FIG. 4 shows a case where the first control signal CS1 is fixed at H. As shown in FIG. 4, for example, in a case where the first control signal CS1 is continuously input to the first gate 21G from the controller 15, the fixation monitoring signal MS exhibits behavior different from the reference signal pattern RP. Specifically, in a case where the first gate voltage is continuously input to the first gate 21G from the controller 15, the fixation monitoring signal MS is the same as the reference signal pattern RP during a period TP1 from the timing T1 at which the first control signal CS1 should change from L to H to the timing T2 at which the first control signal CS1 should change from H to L. However, since the first gate voltage is continuously input to the first gate 21G, the first control signal CS1 is fixed at H during a period TP2 from the timing T2 at which the first control signal CS1 should change to L to the timing T3 at which the first control signal CS1 should change to H. As a result, during the period TP2, the second gate voltage is not supplied to the second gate 22G, and the forced discharge of the rechargeable battery 11 is not properly executed. Therefore, the controller 15 can determine whether the signal fixation has occurred by determining, at any timing within the period TP2, whether the fixation monitoring signal MS is at H as with the reference signal pattern RP.

For example, the controller 15 determines whether the fixation monitoring signal MS is at H by determining whether the voltage input from the fixation monitoring circuit 24 is equal to the second gate voltage. In a case where the voltage input from the fixation monitoring circuit 24 is equal to the second gate voltage during the period TP1, the controller 15 determines that the fixation monitoring signal MS is at H as with the reference signal pattern RP and concludes that no signal fixation has occurred. On the other hand, in a case where the voltage input from the fixation monitoring circuit 24 is different from the second gate voltage during the period TP1, the controller 15 determines that the fixation monitoring signal MS is not at H during the period TP1 and concludes that the signal fixation has occurred.

FIG. 5 shows a case where the first control signal CS1 cannot be controlled by the controller 15. As shown in FIG. 5, for example, in a case where the first gate 21G cannot be connected to the ground within the controller 15, the fixation monitoring signal MS exhibits behavior different from the reference signal pattern RP. Specifically, in a case where the first gate 21G cannot be connected to the ground within the controller 15, during the period TP1 from the timing T1 at which the first control signal CS1 should change to H to the timing T2 at which the first control signal CS1 should change to L, the fixation monitoring signal MS is the same as the reference signal pattern RP. Since the first gate 21G cannot be connected to the ground, however, the first control signal CS1 is fixed at H during the period TP2 from the timing T2 at which the first control signal CS1 should change to L to the timing T3 at which the first control signal CS 1 should change to H. As a result, during the period TP2, the second gate voltage is not supplied to the second gate 22G, and the forced discharge of the rechargeable battery 11 is not properly executed. Therefore, the controller 15 can determine whether signal fixation has occurred by determining, at any timing within the period TP2, whether the fixation monitoring signal MS is at H as with the reference signal pattern RP.

For example, the controller 15 determines whether the fixation monitoring signal MS is at H by determining whether the voltage input from the fixation monitoring circuit 24 is equal to the second gate voltage. In a case where the voltage input from the fixation monitoring circuit 24 is equal to the second gate voltage during the period TP1, the controller 15 determines that the fixation monitoring signal MS is at H as with the reference signal pattern RP and concludes that no signal fixation has occurred. On the other hand, in a case where the voltage input from the fixation monitoring circuit 24 is different from the second gate voltage during the period TP1, the controller 15 determines that the fixation monitoring signal MS is not at H during the period TP1 and concludes that the signal fixation has occurred.

FIG. 6 shows a case where the first control signal CS1 is fixed at L. As shown in FIG. 6, for example, in a case where the connection state between the first gate 21G and the ground cannot be cut off within the controller 15, the fixation monitoring signal MS exhibits behavior different from the reference signal pattern RP. Specifically, in a case where the connection state between the first gate 21G and the ground cannot be cut off within the controller 15, when the controller 15 supplies the power voltage to the first source 21S, the first control signal CS1 is fixed at L at the timing T1 at which the first control signal CS 1 should change from L to H. As a result, the first gate voltage, which is negative, is supplied to the first gate 21G, and the second gate voltage is supplied from the first drain 21D to the second gate 22G. Consequently, the second control signal CS2 changes from L to H at the timing T1 at which the second control signal CS2 should remain L. Therefore, the forced discharge of the rechargeable battery 11 starts at the timing T1 at which the forced discharge should not yet start. Namely, the controller 15 can determine, at any timing within the period TP1, whether the signal fixation has occurred by determining whether the fixation monitoring signal MS is at L as with the reference signal pattern RP.

For example, the controller 15 determines whether the fixation monitoring signal MS is at L by determining whether the voltage input from the fixation monitoring circuit 24 is equal to the second gate voltage. In a case where the voltage input from the fixation monitoring circuit 24 is equal to the second gate voltage during the period TP1, the controller 15 determines that the fixation monitoring signal MS is at L as with the reference signal pattern RP and concludes that no signal fixation has occurred. On the other hand, in a case where the voltage input from the fixation monitoring circuit 24 is different from the second gate voltage during the period TP1, the controller 15 determines that the fixation monitoring signal MS is not at L during the period TP1 and concludes that the signal fixation has occurred.

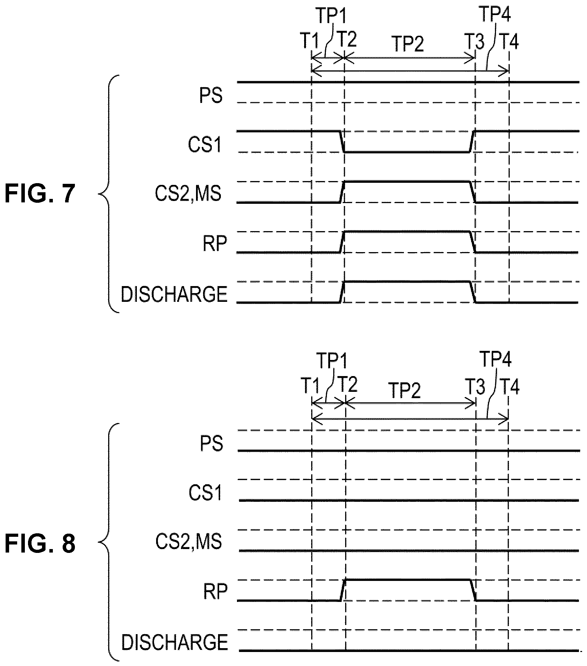

FIG. 7 shows a case where the power signal PS is fixed at H. As shown in FIG. 7, for example, in a case where the controller 15 continuously supplies the power voltage to the first source 21S, the fixation monitoring signal MS exhibits the same behavior as the reference signal pattern RP. In this case, since the forced discharge of the rechargeable battery 11 is correctly executed based on the first control signal CS1, the controller 15 does not determine that the signal fixation has occurred.

FIG. 8 shows a case where the power signal PS is fixed at L. As shown in FIG. 8, for example, in a case where the connection state between the first source 21S and the ground cannot be cut off within the controller 15, the fixation monitoring signal MS exhibits behavior different from the reference signal pattern RP. Specifically, in a case where the connection state between the first source 21S and the ground cannot be cut off within the controller 15, the power signal PS is fixed at L during the period TP4 from the timing T1 at which the power signal PS should change to H to the timing T4 at which the power signal PS should change to L. As a result, the first control signal CS1 does not change to H at the timing T1. Even if the first gate 21G is connected to the ground within the controller 15 at the timing T2, both the power signal PS and the first control signal CS1 remain at L. Consequently, the second gate voltage is not supplied to the second gate 22G, and the second control signal CS2 also remains at L. Thus, the controller 15 can determine whether the signal fixation has occurred by determining, at any timing within the period TP2, whether the fixation monitoring signal MS changes to H as with the reference signal pattern RP.

As shown in FIG. 3, the battery control monitoring device 13 comprises a forced shutdown circuit 25. Namely, the battery control monitoring system 2 comprises the forced shutdown circuit 25. The main device 10 includes the forced shutdown circuit 25. The forced shutdown circuit 25 is configured to forcibly terminate the forced discharge executed by the discharge circuit 20 in a case where the signal fixation occurs. The forced shutdown circuit 25 is electrically connected to the discharge circuit 20 and the controller 15. The forced shutdown circuit 25 is electrically connected to the connection portion 23 between the first switch circuit 21 and the second switch circuit 22 to cut off the second control signal CS2 input to the second switch circuit 22. The forced shutdown circuit 25 includes a first end portion 24B and a second end portion 24C. The first end portion 24B of the forced shutdown circuit 25 is connected to the connection portion 23. The second end portion 24C of the forced shutdown circuit 25 is connected to the controller 15. The forced shutdown circuit 25 may be omitted from the battery control monitoring system 2 and the battery control monitoring device 13.

The controller 15 is configured to determine over-current in a case where the current value of the rechargeable battery 11 exceeds a current threshold during the forced discharge. For example, the controller 15 is configured to determine whether the measured current value exceeds the current threshold after the start of the forced discharge by the discharge circuit 20. The controller 15 is configured to output an over-current determination result indicating that over-current has flowed in a case where the measured current value exceeds the current threshold for a certain period. The controller 15 controls the forced shutdown circuit 25 to forcibly terminate the forced discharge in a case where over-current is detected. Additionally, the controller 15 stops the supply of the first gate voltage and the power voltage in a case where over-current is detected. The controller 15 may also be configured not to determine over-current during the forced discharge.

The controller 15 is configured to calculate an estimated elevated temperature of the rechargeable battery 11 based on the current value of the rechargeable battery 11. For example, the controller 15 calculates a current integrated value by integrating, for a predetermined period, the measured current value obtained during charging or discharging of the rechargeable battery 11. The controller 15 stores first relational information indicating the relationship between the current integrated value and the estimated elevated temperature of the rechargeable battery 11 in the memory 14M. The controller 15 calculates the estimated elevated temperature of the rechargeable battery 11 based on the current integrated value and the first relational information. The controller 15 is configured to output a temperature-increase determination result DR2 indicating that the temperature of the rechargeable battery 11 has significantly increased in a case where the estimated elevated temperature of the rechargeable battery 11 exceeds a temperature threshold. The controller 15 stops supplying the first gate voltage and the power voltage in a case where the temperature of the rechargeable battery 11 has significantly increased. In a case where the temperature increase determination is executed while charging and discharging are being stopped, the controller 15 may control the forced shutdown circuit 25 to forcibly terminate the forced discharge when the temperature of the rechargeable battery 11 has significantly increased. The controller 15 may also be configured not to calculate the estimated elevated temperature of the rechargeable battery 11.

The controller 15 may also be configured to calculate the estimated elevated temperature of the battery control monitoring device 13 based on the current value of the current sensor 18. In this case, for example, the controller 15 calculates a current integrated value by integrating, for a predetermined period, the measured current value obtained during charging or discharging of the rechargeable battery 11. The controller 15 stores second relational information indicating the relationship between the current integrated value and the estimated elevated temperature of the battery control monitoring device 13 in the memory 14M. The controller 15 calculates the estimated elevated temperature of the battery control monitoring device 13 based on the current integrated value and the second relational information. The controller 15 is configured to output the temperature-increase determination result DR2 indicating that the temperature of the battery control monitoring device 13 has significantly increased in a case where the estimated elevated temperature of the battery control monitoring device 13 exceeds a temperature threshold. Additionally, the controller 15 stops supplying the first gate voltage and the power voltage in a case where the temperature of the battery control monitoring device 13 has significantly increased. In a case where the temperature increase determination is executed while charging and discharging are being stopped, the controller 15 may control the forced shutdown circuit 25 to forcibly terminate the forced discharge when the temperature of the battery control monitoring device 13 has significantly increased. The controller 15 may also be configured not to calculate the estimated elevated temperature of the battery control monitoring device 13.

As shown in FIG. 1, the main device 10 comprises a notification device 26. Namely, the battery control monitoring system 2 comprises the notification device 26. The notification device 26 is electrically connected to the controller 15. The notification device 26 is electrically connected to the processor 15P and the memory 15M via the circuit board 15C and the bus 15B. The controller 15 is configured to control the notification device 26 based on the fixation determination result DR1. The notification device 26 operates using the electricity supplied from the controller 15.

The notification device 26 is configured to notify the user of the fixation determination result DR1 of the rechargeable battery 11. The notification device 26 includes at least one of an indicator, a display, and a speaker. The controller 15 is configured to control the notification device 26 to notify the user of the fixation determination result DR1.

The controller 15 controls the notification device 26 to notify the user of the fixation determination result DR1 in a case where the signal fixation occurs. For example, the notification device 26 is configured to display the fixation determination result DR1. This allows the user of the battery control monitoring system 2 (for example, the user of the main device 10) to recognize the fixation determination result DR1.

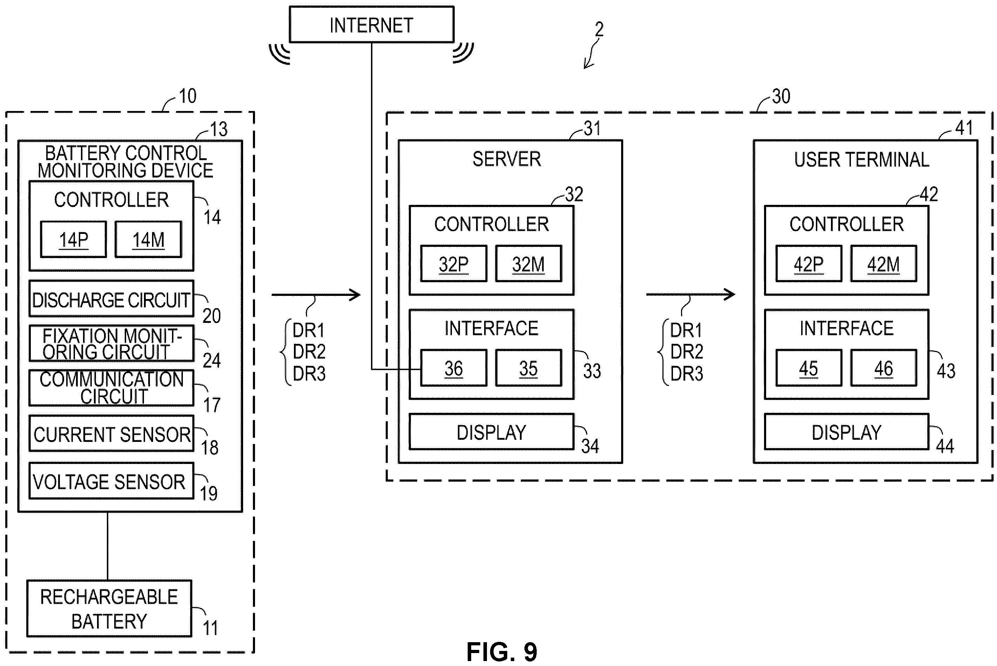

As shown in FIG. 9, the controller 15 is configured to transmit the fixation determination result DR1 indicating the occurrence of the signal fixation to the external device 30 via the communication circuit 17 in a case where the signal fixation occurs. The controller 15 is configured to transmit the fixation determination result DR1 to the external device 30 (at least one of the server 31 and the user terminal 41) via the communication circuit 17 in the case where the signal fixation occurs. The controller 32 of the server 31 transmits the fixation determination result DR1 to the user terminal 41 via the communication unit 36. The controller 42 of the user terminal 41 controls the display 44 to display the fixation determination result DR1. This enables the user of the battery control monitoring system 2 to recognize the fixation determination result DR1.

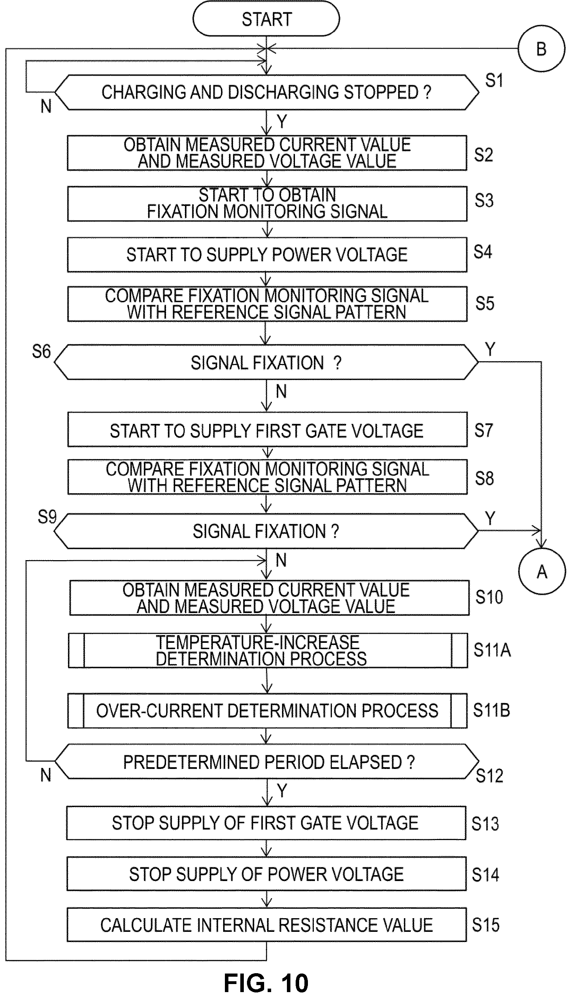

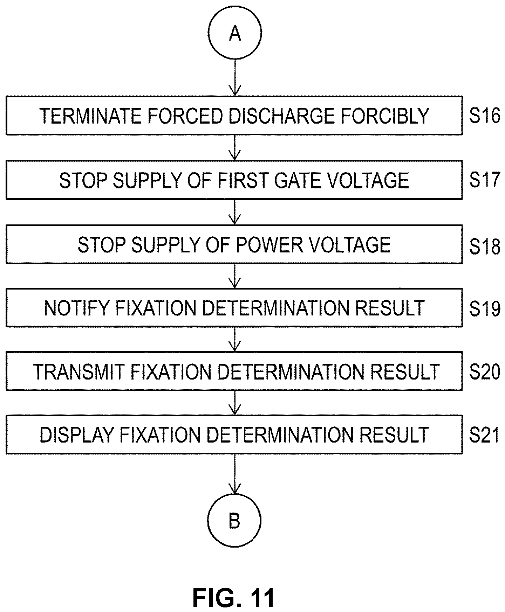

The operation of the battery control monitoring system 2 and the battery control monitoring device 13 will be described with reference to FIGS. 2 and 5 to 11. As shown in FIGS. 10 and 11, the controller 15 is configured to execute the battery control monitoring method described below. The controller 15 stores the battery control monitoring program in the memory 15M. Namely, the computer-readable storage medium 15M stores the battery control monitoring program. The battery control monitoring program causes a computer to execute the battery control monitoring method. The processor 15P of the controller 15 reads and executes the battery control monitoring program stored in the memory 15M to implement the battery control monitoring method described below.

As shown in FIGS. 10 and 11, the battery control monitoring method comprises: controlling, by the controller 15, the discharge circuit 20 to execute the forced discharge of the rechargeable battery 11 using the control signal CS; and monitoring the signal fixation using the fixation monitoring circuit 24.

As shown in FIG. 10, it is determined by the controller 15 whether the rechargeable battery 11 is in the state where charging and discharging are being stopped (step S1). In a case where the rechargeable battery 11 is in the state where charging and discharging are being stopped, the measured current value and the measured voltage value are obtained by the controller 15 (step S2). The measured current value and the measured voltage value are stored in the memory 15M as the current value A0 and the voltage value V0 before the forced discharge. As described later, however, the forced discharge executed by the discharge circuit 20 may be executed regardless of whether charging and discharging of the rechargeable battery 11 are being stopped.

The obtaining of the fixation monitoring signal MS (step S3) is started by the controller 15. For example, the controller 15 starts to obtain, as the fixation monitoring signal MS, the signal indicated by the voltage input from the fixation monitoring circuit 24 to the controller 15. The fixation monitoring signal MS may be obtained from a timing of the power-on of the controller 15. After the start of the obtaining of the fixation monitoring signal MS, the supply of the power voltage from the controller 15 to the discharge circuit 20 is started (step S4). For example, the supply of the power voltage from the controller 15 to the first source 21S of the first switch circuit 21 (see e.g., FIG. 3) is started.

After the start of the supply of the power voltage, the fixation monitoring signal MS is compared with the reference signal pattern RP by the controller 15 (step S6). For example, it is determined by the controller 15 whether the voltage indicated by the fixation monitoring signal MS is equal to the voltage indicated by the reference signal pattern RP after the start of the supply of the power voltage. In a case where the voltage indicated by the fixation monitoring signal MS is equal to the voltage indicated by the reference signal pattern RP after the start of the supply of the power voltage (see e.g., the timing T1 in FIG. 2), it is determined by the controller 15 that the signal fixation has not occurred. On the other hand, in a case where the voltage indicated by the fixation monitoring signal MS is different from the voltage indicated by the reference signal pattern RP after the start of the supply of the power voltage (see e.g., the timing T1 in FIG. 6), it is determined by the controller 15 that the signal fixation has occurred. In a case where it is determined that the signal fixation has occurred, the process proceeds to step S16 shown in FIG. 11.

In a case where it is determined that the signal fixation has not occurred, the supply of the first gate voltage to the discharge circuit 20 is started by the controller 15 (step S7). For example, the supply of the first gate voltage from the controller 15 to the first gate 21G of the first switch circuit 21 (see e.g., FIG. 3) is started.

After the start of the supply of the first gate voltage, the fixation monitoring signal MS is compared with the reference signal pattern RP by the controller 15 (step S8). For example, the controller 15 determines whether the voltage indicated by the fixation monitoring signal MS is equal to the voltage indicated by the reference signal pattern RP after the start of the supply of the first gate voltage. In a case where the voltage indicated by the fixation monitoring signal MS is equal to the voltage indicated by the reference signal pattern RP after the start of the supply of the first gate voltage (see e.g., the timing T2 in FIG. 2), it is determined by the controller 15 that the signal fixation has not occurred. On the other hand, in a case where the voltage indicated by the fixation monitoring signal MS is different from the voltage indicated by the reference signal pattern RP after the start of the supply of the first gate voltage (see e.g., the timing T2 in FIGS. 5 and 8), the controller 15 determines that the signal fixation has occurred. In a case where it is determined that the signal fixation has occurred, the process proceeds to step S16 shown in FIG. 11.

In a case where it is determined that the signal fixation has not occurred, the measured current value and the measured voltage value are obtained by the controller 15 (step S10). The measured current value and the measured voltage value are stored in the memory 15M as the current value A1 and the voltage value V1 during the forced discharge.

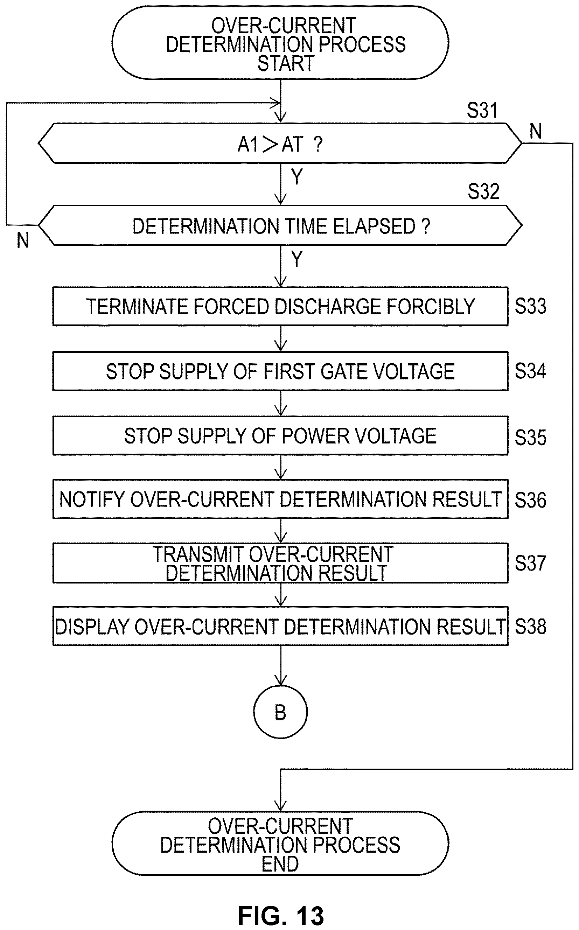

In a case where the signal fixation has not occurred, a temperature-increase determination process and an over-current determination process shown in FIG. 13 are executed (steps S11A and S 11B). The temperature-increase determination process and the over-current determination process will be described later.

In a case where no temperature increase is detected in the temperature-increase determination process and no over-current is detected in the over-current determination process, it is determined by the controller 15 whether a predetermined period has elapsed (step S12). The predetermined period corresponds to the discharge time and is counted, for example, from the start of the power voltage. After the predetermined period has elapsed, the supply of the first gate voltage is stopped by the controller 15 (step S13). As a result, the second switch circuit 22 switches from the connection state to the cut-off state, and the forced discharge of the rechargeable battery 11 is stopped. After stopping the supply of the first gate voltage, the supply of the power voltage is stopped by the controller 15 (step S14).

The internal resistance value R is calculated by the controller 15 based on the current value A0, the voltage value V0, the current value A1, and the voltage value V1 which are obtained in steps S2 and S10 and the equation (1) (step S15).

In a case where it is determined in one of steps S6 and S9 shown in FIG. 10 that the signal fixation has occurred, as shown in FIG. 11, the forced discharge is forcibly terminated by the forced shutdown circuit 25 (step S16). Specifically, in a case where it is determined that the signal fixation has occurred, the second control signal CS2 input to the second switch circuit 22 is cut off by the forced shutdown circuit 25. As a result, the forced discharge executed by the discharge circuit 20 is forcibly terminated. Additionally, in a case where it is determined that the signal fixation has occurred, the supply of the first gate voltage and the power voltage is stopped (steps S17 and S18). After the forced discharge is terminated, the fixation determination result DR1 indicating that the signal fixation has occurred is notified to the user via the notification device 26 (step S19).

The fixation determination result DR1 is transmitted from the controller 15 to the external device 30 (at least one of the server 31 and the user terminal 41) via the communication circuit 17 (step S20). For example, the fixation determination result DR1 is transmitted from the controller 15 to the server 31 via the communication circuit 17 and is transmitted from the server 31 to the user terminal 41. The fixation determination result DR1 is displayed on the display 44 of the user terminal 41 (step S21). Thus, the user of the battery control monitoring system 2 can recognize the fixation determination result DR1. The process returns to step S1 shown in FIG. 10.

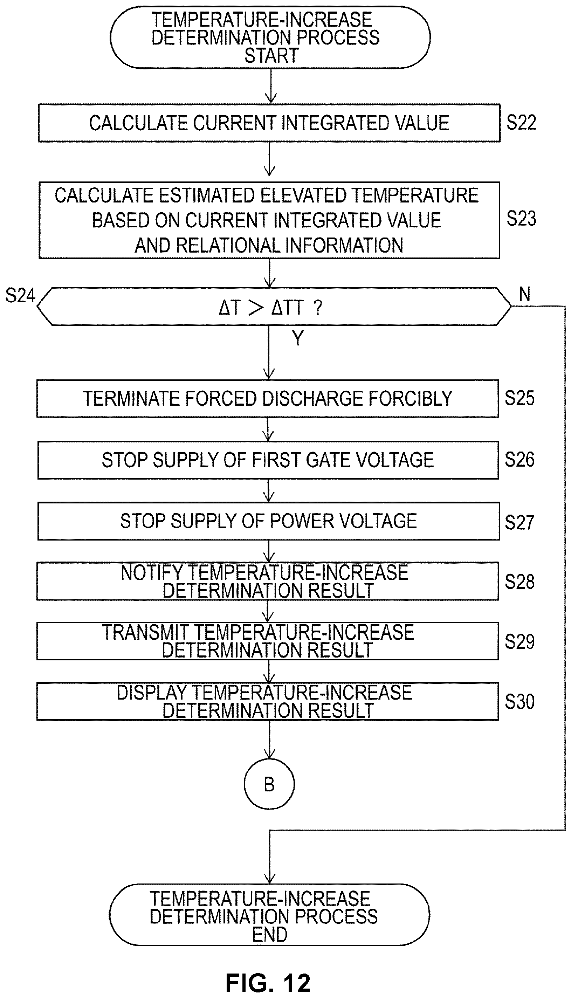

In the temperature-increase determination process shown in FIG. 12, the current integrated value is calculated by the controller 15 by integrating the measured current value obtained during charging or discharging of the rechargeable battery 11 for a predetermined period (step S22). The estimated elevated temperature $\Delta T$ of the rechargeable battery 11 is calculated by the controller 15 based on the current integrated value and the first relational information (step S23). The estimated elevated temperature $\Delta T$ of the battery control monitoring device 13 may also be calculated by the controller 15 based on the current integrated value and the second relational information (step S23). It is determined by the controller 15 whether the estimated elevated temperature $\Delta T$ exceeds the temperature threshold $\Delta TT$ (step S24). In a case where the estimated elevated temperature $\Delta T$ does not exceed the temperature threshold $\Delta TT$, the process proceeds to step S 11B shown in FIG. 10. On the other hand, in a case where the estimated elevated temperature $\Delta T$ exceeds the temperature threshold $\Delta TT$, in a case where the estimated elevated temperature $\Delta T$ exceeds the temperature threshold $\Delta TT$ in step S24, as with steps S16 to S18 shown in FIG. 11, the forced discharge is forcibly terminated by the forced shutdown circuit 25 (step S25), and the supply of the first gate voltage and the power voltage is stopped (steps S26 and S27). After the forced discharge is terminated, the temperature-increase determination result DR2 indicating that the temperature of at least one of the rechargeable battery 11 and the battery control monitoring device 13 has significantly increased is output by the controller 15. The temperature-increase determination result DR2 is notified to the user via the notification device 26 (step S28).

The temperature-increase determination result DR2 is transmitted from the controller 15 to the external device 30 (at least one of the server 31 and the user terminal 41) via the communication circuit 17 (steps S29, see FIG. 3). For example, the temperature-increase determination result DR2 is transmitted from the controller 15 to the server 31 via the communication circuit 17 and is transmitted from the server 31 to the user terminal 41 (see FIG. 3). The temperature-increase determination result DR2 is displayed on the display 44 of the user terminal 41 (step S30). Thus, the user of the battery control monitoring system 2 can recognize the temperature-increase determination result DR2. The process returns to step S1 shown in FIG. 10.

In the over-current determination process shown in FIG. 13, it is determined by the controller 15 whether the current value A1 exceeds the current threshold AT (step S31). In a case where the current value A1 does not exceed the current threshold AT, the process proceeds to step S12 in FIG. 10. On the other hand, in a case where the current value A1 exceeds the current threshold AT, it is determined by the controller 15 whether the determination time has elapsed (step S32). In a case where the determination time has not elapsed, step S31 is repeated. In a case where the determination time has elapsed, since the current value A1 has exceeded the current threshold AT for a certain period, and it is determined than over-current is flowing. In this case, the forced discharge is forcibly terminated by the forced shutdown circuit 25 (step S33). The supply of the first gate voltage and the power voltage is stopped (steps S34 and S35), and the forced discharge is terminated. After the forced discharge is terminated, the over-current determination result DR3 indicating that over-current is flowing is notified to the user via the notification device 26 (step S36).

The over-current determination result DR3 is transmitted from the controller 15 to the external device 30 (at least one of the server 31 and the user terminal 41) via the communication circuit 17 (step S37, see FIG. 3). For example, the over-current determination result DR3 is transmitted from the controller 15 to the server 31 via the communication circuit 17 and is transmitted from the server 31 to the user terminal 41 (see FIG. 3). The over-current determination result DR3 is displayed on the display 44 of the user terminal 41 (step S38). Thus, the user of the battery control monitoring system 2 can recognize the over-current determination result DR3. The process returns to step S1 shown in FIG. 10.

As described above, the battery control monitoring system 2 comprises the discharge circuit 20, the controller 15, and the fixation monitoring circuit 24. The discharge circuit 20 is configured to execute the forced discharge of the rechargeable battery 11 while charging and discharging of the rechargeable battery 11 are stopped. The controller 15 is electrically connected to the discharge circuit 20 and is configured to control the forced discharge executed by the discharge circuit 20 using the control signal CS. The fixation monitoring circuit 24 is electrically connected to the controller 15 and is configured to monitor the signal fixation.

With the battery control monitoring system 2, since the signal fixation can be monitored using the fixation monitoring circuit 24, a malfunction of at least one of the discharge circuit 20 and the controller 15 can be detected. Accordingly, the decrease in the accuracy of arithmetic processing using the forced discharge executed by the discharge circuit 20 can be reduced.

The battery control monitoring method comprises: controlling the discharge circuit 20 to execute, using the control signal CS by the controller 15, the forced discharge of the rechargeable battery 11 while charging and discharging of the rechargeable battery 11 are stopped; and monitoring the signal fixation using the fixation monitoring circuit 24.

With the battery control monitoring method, since the signal fixation can be monitored using the fixation monitoring circuit 24, at least one malfunction of the discharge circuit 20 and the controller 15 can be detected. Therefore, the reduction in the accuracy of arithmetic processing using the forced discharge executed by the discharge circuit 20 can be suppressed.

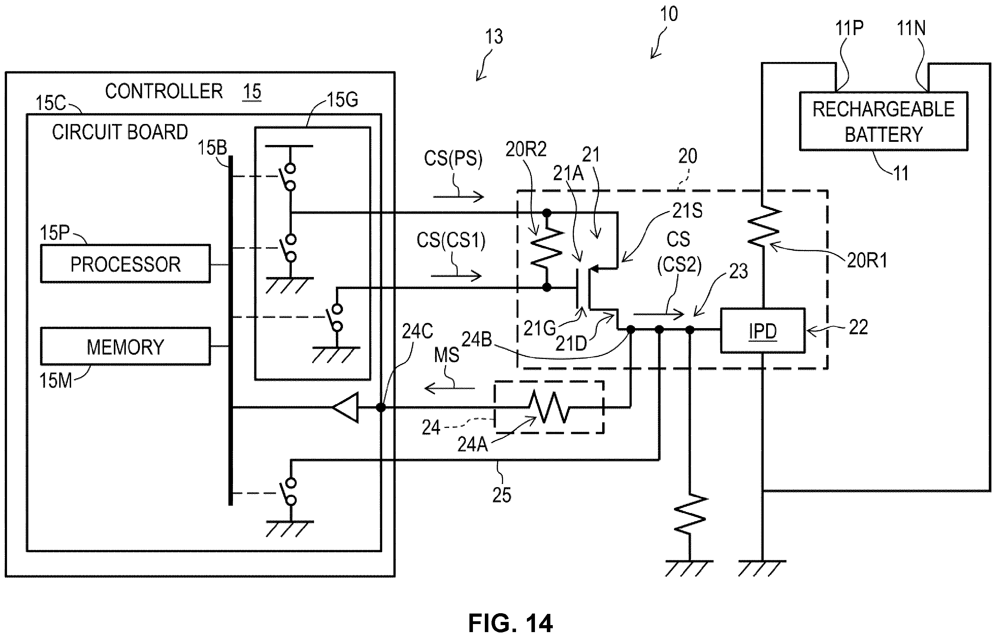

In the aforementioned embodiment, the discharge circuit 20 includes the first switch circuit 21 and the second switch circuit 22. However, the configuration of the discharge circuit 20 is not limited to the first switch circuit 21 and the second switch circuit 22. Although the second switch circuit 22 includes only an N-channel MOSFET in FIG. 3, the second switch circuit 22 may include an Intelligent Power Device (IPD) as shown in FIG. 14. In the modification shown in FIG. 14, the IPD includes a semiconductor switch such as an N-channel MOSFET and other circuits (e.g., protection circuits). When the second switch circuit 22 includes an IPD, the over-current detection process described above may be executed by the IPD.

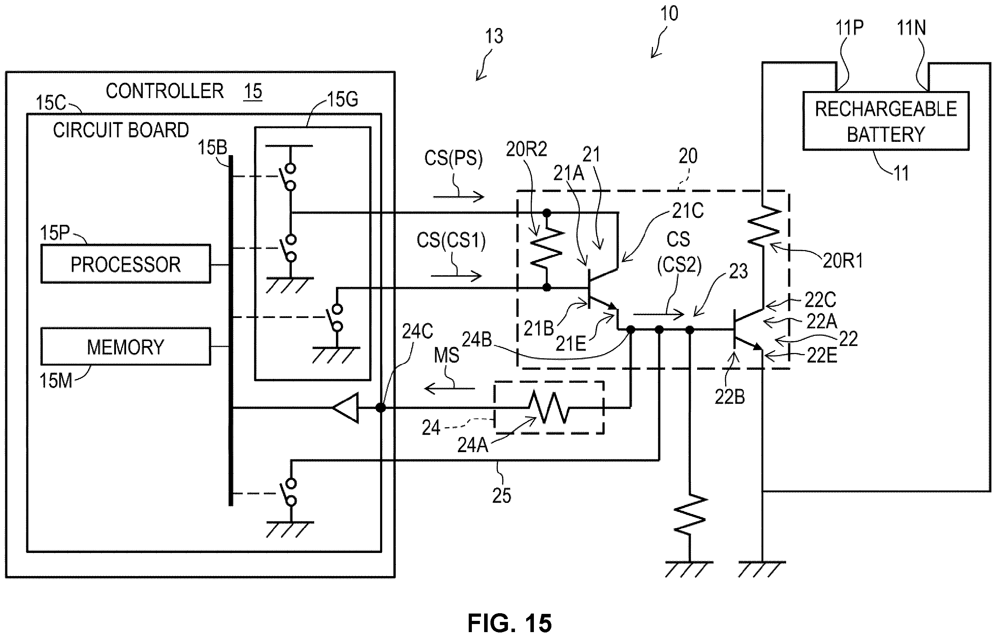

At least one of the first switch circuit 21 and the second switch circuit 22 can include a bipolar transistor. For example, in the battery control monitoring system 2 according to the modification shown in FIG. 15, the first switch circuit 21 includes a first bipolar transistor. The first bipolar transistor includes a first base 21B, a first collector 21C, and a first emitter 21E. The controller 15 is electrically connected to the first base 21B to supply the first control signal CS 1 to the first base 21B. The controller 15 is electrically connected to one of the first collector 21C and the first emitter 21E to supply the power signal PS to one of the first collector 21C and the first emitter 21E. The other of the first collector 21C and the first emitter 21E is electrically connected to the second switch circuit 22. The first bipolar transistor is configured to switch, based on the first control signal CS1 supplied to the first base 21B, between a first conduction state in which electrical conduction is allowed between the first collector 21C and the first emitter 21E and a first cut-off state in which electrical conduction is cut off between the first collector 21C and the first emitter 21E.

In the modification shown in FIG. 15, the first bipolar transistor is an NPN bipolar transistor. Therefore, the controller 15 is electrically connected to the first collector 21C to supply the power signal PS to the first collector 21C. The first emitter 21E is electrically connected to the second switch circuit 22. However, the first bipolar transistor may be a PNP bipolar transistor. In that case, the controller 15 is electrically connected to the first emitter 21E to supply the power signal PS to the first emitter 21E. The first collector 21C is electrically connected to the second switch circuit 22.

As shown in FIG. 15, the second switch circuit 22 includes a second bipolar transistor. The second bipolar transistor includes a second base 22B, a second collector 22C, and a second emitter 22E. The second base 22B is connected to one of the first collector 21C and the first emitter 21E to receive the second control signal CS2 from the first switch circuit 21. One of the second collector 22C and the second emitter 22E is configured to be electrically connected to the rechargeable battery 11.

In the modification shown in FIG. 15, the second bipolar transistor is an NPN bipolar transistor. Therefore, the second collector 22C is configured to be electrically connected to the rechargeable battery 11. However, the second bipolar transistor may be a PNP bipolar transistor. In that case, the second emitter 22E is configured to be electrically connected to the rechargeable battery 11.

The first switch circuit 21 may include a field effect transistor, a bipolar transistor, and other power devices. The second switch circuit 22 may include a field effect transistor, a bipolar transistor, and other power devices. At least part of the embodiment shown in FIG. 3 and the modifications shown in FIGS. 14 and 15 may be combined.

In the embodiment shown in FIG. 3 and the modifications shown in FIGS. 14 and 15, the discharge circuit 20 includes the first switch circuit 21. However, the first switch circuit 21 may be considered part of the fixation monitoring circuit 24.

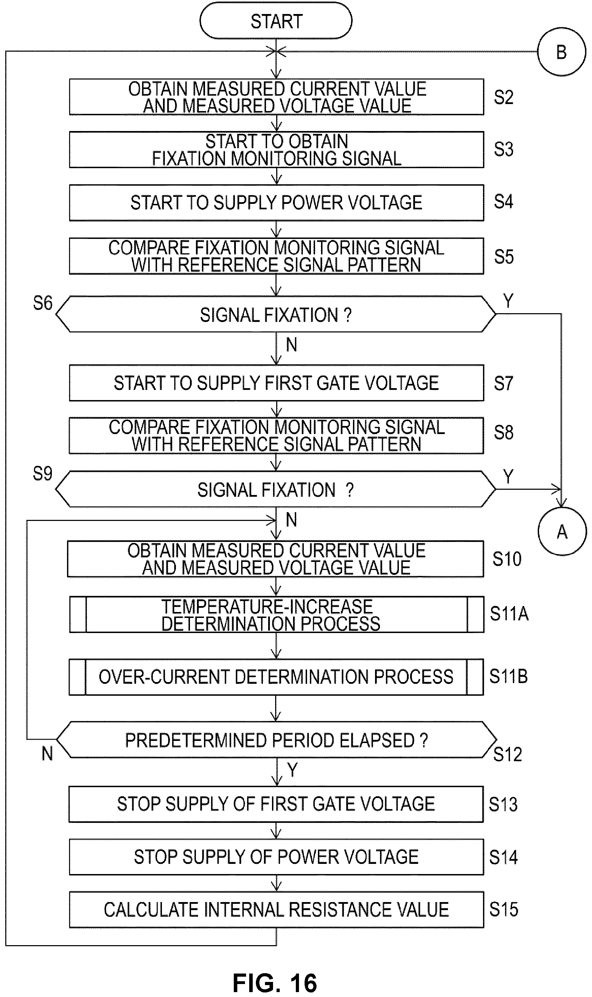

In the flowchart shown in FIG. 10, the controller 15 determines whether the rechargeable battery 11 is in the state where charging and discharging are being stopped in step S1. However, the forced discharge executed by the discharge circuit 20 may be executed regardless of whether the rechargeable battery 11 is in the state where charging and discharging are being stopped. In that case, as shown in FIG. 16, step S1 may be omitted from the battery control monitoring method. In a case where step S1 is omitted, the current sensor 18 may include a first current sensor that measures the discharge current value during the forced discharge executed by the discharge circuit 20 and a second current sensor that measures the current value (the charge current value and the discharge current value) other than during the forced discharge. By providing the first current sensor dedicated to the discharge circuit 20, it is possible to more reliably determine the temperature increase and the over-current which are caused by the forced discharge.

In the aforementioned embodiment, the controller 15 mounted on the main device 10 executes steps S1 to S18 shown in FIGS. 10 and 11. However, at least one of the controller 32 of the server 31 and the controller 42 of the user terminal 41 may be configured to execute at least part of steps S1 to S21.

For example, step S14 shown in FIG. 9 may be executed by the external device 30 (one of the server 31 and the user terminal 41). In this case, the current value A0, the voltage value V0, the current value A1, and the voltage value V1 are transmitted to the external device 30 (one of the server 31 and the user terminal 41) via the communication circuit 17, and the internal resistance value R is calculated by the external device 30.

The current value A0, the voltage value V0, the current value A1, and the voltage value V1 may be used for purposes other than calculating the internal resistance value R.

In the battery control monitoring system 2, the battery control monitoring device 13, the battery control monitoring method, and the battery control monitoring program according to the aforementioned embodiment and their modifications, the battery control monitoring device 13 comprises the discharge circuit 20 and the fixation monitoring circuit 24. However, at least one of the discharge circuit 20 and the fixation monitoring circuit 24 may be provided within the main device 10 and outside the battery control monitoring device 13.

The battery control monitoring system 2, the battery control monitoring device 13, the battery control monitoring method, and the battery control monitoring program according to the aforementioned embodiment and their modifications are applicable to vehicles owned by individuals, rental cars, and vehicles used for car sharing. In a case where the battery control monitoring system 2 and the battery control monitoring device 13 are applied to vehicles owned by individuals, for example, the user terminal 41 is used by the vehicle owner or driver to monitor the signal fixation in the battery control monitoring device 13 installed in the vehicle. In a case where the battery control monitoring system 2 and the battery control monitoring device 13 are applied to rental cars, for example, the user terminal 41 is used by the rental car company and its staff to monitor the signal fixation in the battery control monitoring device 13 installed in the rented vehicle. In a case where the battery control monitoring system 2 and the battery control monitoring device 13 are applied to vehicles used for car sharing, for example, the user terminal 41 is used by the car sharing company and its staff to monitor the signal fixation in the battery control monitoring device 13 installed in the shared vehicle.

The battery control monitoring system 2, the battery control monitoring device 13, the battery control monitoring method, and the battery control monitoring program according to the aforementioned embodiment and their modifications are also applicable to devices other than vehicles. The battery control monitoring system 2, the battery control monitoring device 13, the battery control monitoring method, and the battery control monitoring program according to the aforementioned embodiment and their modifications are also applicable to devices that monitor rechargeable batteries that store electricity generated by systems such as photovoltaic power generation systems.

The battery control monitoring system 2 described above is merely one example of a battery control monitoring system, and the configuration of the battery control monitoring system is not limited to the configuration of the battery control monitoring system 2. For example, in the aforementioned embodiment, the battery control monitoring system 2 comprises the battery control monitoring device 13, the external device 30, and the external device 30. However, the external device 30 (at least one of the server 31 and the user terminal 41) may be omitted from the battery control monitoring system 2, or the battery control monitoring system 2 may include other configurations. The same applies to the modifications of the battery control monitoring system 2.

The battery control monitoring system 2 comprises the power circuit 16, the communication circuit 17, the current sensor 18, and the voltage sensor 19. However, at least one of the power circuit 16, the communication circuit 17, the current sensor 18, and the voltage sensor 19 may be omitted from the battery control monitoring system 2 or the battery control monitoring device 13. The battery control monitoring system 2 or the battery control monitoring device 13 may include other configurations. In a case where at least one of the power circuit 16, the communication circuit 17, the current sensor 18, and the voltage sensor 19 is omitted from the battery control monitoring system 2, the battery control monitoring system 2 can be configured to obtain necessary information (e.g., current value, temperature) from outside the battery control monitoring system 2. At least one of the power circuit 16, the communication circuit 17, the current sensor 18, and the voltage sensor 19 may be mounted to a part other than the battery control monitoring device 13 within the main device 10. The same applies to the modifications of the battery control monitoring system 2, the battery control monitoring device 13, and the modifications of the battery control monitoring device 13.

In the present application, the term "comprising" and its derivatives are open-ended terms that describe the presence of constituent elements and do not exclude the presence of other constituent elements not described. This concept also applies to the terms "having," "including," and their derivatives.

In the present application, ordinal numbers such as "first" and "second" are merely identifiers, but do not have any other meanings (e.g., a particular order and the like). For example, the term "first element" does not imply an existence of "second element," and the term "second element" does not imply an existence of "first element."

Terms of degree such as "substantially," "about" and "approximately" as used herein mean a reasonable amount of deviation of the modified term such that the end result is not significantly changed. All of numerical values described in the present application can be construed as including the terms such as "substantially," "about" and "approximately."

The phrase "at least one of A and B" in the present disclosure encompasses, for example, (1) A alone, (2) B alone, and (3) both A and B. The phrase "at least one of A, B, and C" encompasses, for example, (1) A alone, (2) B alone, (3) C alone, (4) A and B, (5) B and C, (6) A and C, and (7) all A, B, and C. In the present disclosure, the phrase "at least one of A and B" is not interpreted as "at least one of A and at least one of B."

In view of the above disclosure, it is obvious that various changes and modifications of the present invention are possible. Therefore, the present invention may be implemented in a manner different from that of the specific disclosure of the present application to the extent that it does not depart from the intent of the present invention.

Reference Signs List

2: Battery control monitoring system
10: Main device
11: Rechargeable battery
12: Load
13: Battery control monitoring device
14: Charging circuit
16: Power circuit
17: Communication circuit
18: Current sensor
19: Voltage sensor
20: Discharge circuit
21: First switch circuit
21A: First field effect transistor
21D: First drain
21G: First gate
21S: First source
22: Second switch circuit
22A: Second field effect transistor
22D: Second drain
22G: Second gate
22S: Second source
23: Connection portion
24: Fixation monitoring circuit

24A: Fixation detection resistor
25: Forced shutdown circuit
26: Notification device
30: External device
31: Server
CS: Control signal
CS1: First control signal
CS2: Second control signal
DR: Fixation determination result
MS: Fixation monitoring signal
PS: Power signal
R: Internal resistance value
RP: Reference signal pattern

**Claims**

1. A battery control monitoring system comprising:

   a discharge circuit configured to execute forced discharge of a rechargeable battery;
   a controller electrically connected to the discharge circuit and configured to control the forced discharge executed by the discharge circuit using a control signal; and
   a fixation monitoring circuit electrically connected to the controller and configured to monitor signal fixation.

2. The battery control monitoring system according to claim 1, wherein

   the fixation monitoring circuit is electrically connected to the controller to input a fixation monitoring signal indicating a state of the discharge circuit to the controller, and
   the controller is configured to determine the signal fixation based on the fixation monitoring signal.

3. The battery control monitoring system according to claim 2, wherein
   the controller is configured to determine the signal fixation by comparing the fixation monitoring signal with a reference signal pattern.

4. The battery control monitoring system according to claim 3, wherein

   the control signal includes a first control signal,
   the controller is configured to output the first control signal to the discharge circuit,
   the discharge circuit is configured to execute the forced discharge based on the first control signal, and
   the reference signal pattern includes a pattern of the fixation monitoring signal in a case where the first control signal is not fixed.

5. The battery control monitoring system according to claim 3 or 4, wherein

the control signal includes a power signal different from the first control signal,
the controller is configured to output the power signal to the discharge circuit,
the discharge circuit is configured to execute the forced discharge based on the first control signal and the power signal, and
the reference signal pattern includes a pattern of the fixation monitoring signal in a case where the power signal is not fixed.

6. The battery control monitoring system according to claim 5, wherein the discharge circuit includes

a first switch circuit electrically connected to the controller, and
the second switch circuit electrically connected to the first switch circuit,
the second switch circuit has
a connection state in which a positive terminal of the rechargeable battery and a negative terminal of the rechargeable battery are electrically connected, and
a cut-off state in which an electrical connection between the positive terminal of the rechargeable battery and the negative terminal of the rechargeable battery is cut off,
the first switch circuit is configured to output a second control signal based on the first control signal and the power signal, and
the second switch circuit is configured to switch between the connection state and the cut-off state based on the second control signal.

7. The battery control monitoring system according to claim 6, wherein
the fixation monitoring circuit is electrically connected to a connection portion between the first switch circuit and the second switch circuit to input the second control signal to the controller as the fixation monitoring signal.

8. The battery control monitoring system according to claim 6 or 7, wherein

the first switch circuit includes a first field effect transistor,
the first field effect transistor includes a first gate, a first source, and a first drain,
the controller is electrically connected to the first gate to supply the first control signal to the first gate,
the controller is electrically connected to one of the first source and the first drain to supply the power signal to the one of the first source and the first drain,
the other of the first source and the first drain is electrically connected to the second switch circuit, and
the first field effect transistor is configured to switch, based on the first control signal supplied to the first gate, between
a first conduction state in which electrical conduction is allowed between the first source and the first drain, and
a first cut-off state in which electrical conduction is cut off between the first source and the first drain.

9. The battery control monitoring system according to claim 8, wherein

the second switch circuit includes a second field effect transistor,
the second field effect transistor includes a second gate, a second source, and a second drain,
the second gate is connected to one of the first source and the first drain to receive the second control signal from the first switch circuit, and
one of the second source and the second drain is configured to be electrically connected to the rechargeable battery.

10. The battery control monitoring system according to claim 6 or 7, wherein

the first switch circuit includes a first bipolar transistor,
the first bipolar transistor includes a first base, a first collector, and a first emitter,
the controller is electrically connected to the first base to supply the first control signal to the first base,
the controller is electrically connected to one of the first collector and the first emitter to supply the power signal to the one of the first collector and the first emitter,
the other of the first collector and the first emitter is electrically connected to the second switch circuit, and
the first bipolar transistor is configured to switch, based on the first control signal supplied to the first base, between
a first conduction state in which electrical conduction is allowed between the first collector and the first emitter, and
a first cut-off state in which electrical conduction is cut off between the first collector and the first emitter.

11. The battery control monitoring system according to claim 10, wherein

the second switch circuit includes a second bipolar transistor,

the second bipolar transistor includes a second base, a second collector, and a second emitter,

the second base is connected to one of the first collector and the first emitter to receive the second control signal from the first switch circuit, and

one of the second collector and the second emitter is configured to be electrically connected to the rechargeable battery.

12. The battery control monitoring system according to any one of claims 5 to 11, wherein the discharge circuit includes a protective resistor connecting a line of the first control signal and a line of the power signal.

13. The battery control monitoring system according to any one of claims 1 to 12, wherein the fixation monitoring circuit includes a fixation detection resistor electrically connected to the discharge circuit and the controller.

14. The battery control monitoring system according to any one of claims 1 to 13, wherein the controller is configured to determine over-current in a case where a current value of the rechargeable battery exceeds a current threshold during the forced discharge.

15. The battery control monitoring system according to any one of claims 1 to 14, wherein the controller is configured to calculate an estimated elevated temperature of the rechargeable battery based on the current value of the rechargeable battery.

16. The battery control monitoring system according to any one of claims 1 to 15, further comprising a forced shutdown circuit configured to forcibly terminate the forced discharge executed by the discharge circuit in a case where the signal fixation occurs.

17. The battery control monitoring system according to any one of claims 1 to 16, further comprising:

a main device; and
an external device configured to communicate with the main device, wherein

the main device includes the controller, the fixation monitoring circuit, and a communication circuit configured to communicate with the external device, and

the controller is configured to transmit a fixation determination result indicating occurrence of the signal fixation to the external device via the communication circuit in a case where the signal fixation occurs.

18. A battery control monitoring device comprising:

a discharge circuit configured to execute forced discharge of a rechargeable battery;
a controller electrically connected to the discharge circuit and configured to control the forced discharge executed by the discharge circuit using a control signal; and
a fixation monitoring circuit electrically connected to the controller and configured to monitor signal fixation.

19. A battery control monitoring method comprising:

controlling a discharge circuit using a control signal to execute forced discharge of a rechargeable battery by a controller; and
monitoring signal fixation by a fixation monitoring circuit.

20. A battery control monitoring program causing a computer to execute the battery control monitoring method according to claim 19.

21. A computer-readable storage medium storing the battery control monitoring program according to claim 20.

**FIG. 1**

FIG. 2

**FIG. 3**

EP 4 503 258 A1

FIG. 4

FIG. 5

FIG. 6

**FIG. 7**

PS

CS1

CS2,MS

RP

DISCHARGE

TP1
T1 T2 TP2 T3 T4
TP4

**FIG. 8**

PS

CS1

CS2,MS

RP

DISCHARGE

TP1
T1 T2 TP2 T3 T4
TP4

**FIG. 9**

EP 4 503 258 A1

START

B

CHARGING AND DISCHARGING STOPPED ?    S1
N

Y

OBTAIN MEASURED CURRENT VALUE
AND MEASURED VOLTAGE VALUE    S2

START TO OBTAIN
FIXATION MONITORING SIGNAL    S3

START TO SUPPLY POWER VOLTAGE    S4

COMPARE FIXATION MONITORING SIGNAL
WITH REFERENCE SIGNAL PATTERN    S5

S6    SIGNAL FIXATION ?    Y

N

START TO SUPPLY FIRST GATE VOLTAGE    S7

COMPARE FIXATION MONITORING SIGNAL
WITH REFERENCE SIGNAL PATTERN    S8

S9    SIGNAL FIXATION ?    Y

N    A

OBTAIN MEASURED CURRENT VALUE
AND MEASURED VOLTAGE VALUE    S10

TEMPERATURE-INCREASE
DETERMINATION PROCESS    S11A

OVER-CURRENT DETERMINATION PROCESS    S11B

PREDETERMINED PERIOD ELAPSED ?    S12
N

Y

STOP SUPPLY OF FIRST GATE VOLTAGE    S13

STOP SUPPLY OF POWER VOLTAGE    S14

CALCULATE INTERNAL RESISTANCE VALUE    S15

**FIG. 10**

```
          ( A )
            │
            ▼
TERMINATE FORCED DISCHARGE FORCIBLY   S16
            │
            ▼
STOP SUPPLY OF FIRST GATE VOLTAGE     S17
            │
            ▼
STOP SUPPLY OF POWER VOLTAGE          S18
            │
            ▼
NOTIFY FIXATION DETERMINATION RESULT  S19
            │
            ▼
TRANSMIT FIXATION DETERMINATION RESULT  S20
            │
            ▼
DISPLAY FIXATION DETERMINATION RESULT  S21
            │
            ▼
          ( B )
```

**FIG. 11**

TEMPERATURE-INCREASE
DETERMINATION PROCESS
START

CALCULATE CURRENT INTEGRATED VALUE | S22

CALCULATE ESTIMATED ELEVATED TEMPERATURE
BASED ON CURRENT INTEGRATED VALUE
AND RELATIONAL INFORMATION | S23

S24 $\Delta T > \Delta TT$ ? N

Y

TERMINATE FORCED DISCHARGE FORCIBLY | S25

STOP SUPPLY OF FIRST GATE VOLTAGE | S26

STOP SUPPLY OF POWER VOLTAGE | S27

NOTIFY TEMPERATURE-INCREASE
DETERMINATION RESULT | S28

TRANSMIT TEMPERATURE-INCREASE
DETERMINATION RESULT | S29

DISPLAY TEMPERATURE-INCREASE
DETERMINATION RESULT | S30

B

TEMPERATURE-INCREASE
DETERMINATION PROCESS
END

**FIG. 12**

```
        ┌─────────────────────┐
        │   OVER-CURRENT      │
        │ DETERMINATION PROCESS│
        │       START         │
        └─────────────────────┘
                  │
                  ▼
```

S31

A1 > AT ? ─── N

│ Y

S32

DETERMINATION TIME ELAPSED ? ─── N

│ Y

| TERMINATE FORCED DISCHARGE FORCIBLY | S33 |

| STOP SUPPLY OF FIRST GATE VOLTAGE | S34 |

| STOP SUPPLY OF POWER VOLTAGE | S35 |

| NOTIFY OVER-CURRENT DETERMINATION RESULT | S36 |

| TRANSMIT OVER-CURRENT DETERMINATION RESULT | S37 |

| DISPLAY OVER-CURRENT DETERMINATION RESULT | S38 |

( B )

```
        ┌─────────────────────┐
        │   OVER-CURRENT      │
        │ DETERMINATION PROCESS│
        │        END          │
        └─────────────────────┘
```

**FIG. 13**

**FIG. 14**

EP 4 503 258 A1

**FIG. 15**

EP 4 503 258 A1

START

B

OBTAIN MEASURED CURRENT VALUE
AND MEASURED VOLTAGE VALUE | S2

START TO OBTAIN
FIXATION MONITORING SIGNAL | S3

START TO SUPPLY POWER VOLTAGE | S4

COMPARE FIXATION MONITORING SIGNAL
WITH REFERENCE SIGNAL PATTERN | S5

S6 SIGNAL FIXATION ? Y

N

START TO SUPPLY FIRST GATE VOLTAGE | S7

COMPARE FIXATION MONITORING SIGNAL
WITH REFERENCE SIGNAL PATTERN | S8

S9 SIGNAL FIXATION ? Y

N A

OBTAIN MEASURED CURRENT VALUE
AND MEASURED VOLTAGE VALUE | S10

TEMPERATURE-INCREASE
DETERMINATION PROCESS | S11A

OVER-CURRENT DETERMINATION PROCESS | S11B

PREDETERMINED PERIOD ELAPSED ? S12

N

Y

STOP SUPPLY OF FIRST GATE VOLTAGE | S13

STOP SUPPLY OF POWER VOLTAGE | S14

CALCULATE INTERNAL RESISTANCE VALUE | S15

FIG. 16

# EP 4 503 258 A1

<table>
<tr><td colspan="2"><strong>INTERNATIONAL SEARCH REPORT</strong></td><td>International application No.<br><br><strong>PCT/JP2023/012834</strong></td></tr>
</table>

<table>
<tr><td colspan="3"><strong>A. CLASSIFICATION OF SUBJECT MATTER</strong><br><br><em>H01M 10/48</em>(2006.01)i; <em>G01R 31/00</em>(2006.01)i; <em>H01M 10/42</em>(2006.01)i; <em>H02J 7/00</em>(2006.01)i<br>FI: H01M10/48 P; H01M10/42 P; H02J7/00 Q; G01R31/00<br><br>According to International Patent Classification (IPC) or to both national classification and IPC</td></tr>
<tr><td colspan="3"><strong>B. FIELDS SEARCHED</strong></td></tr>
<tr><td colspan="3">Minimum documentation searched (classification system followed by classification symbols)<br>H01M10/48; G01R31/00; H01M10/42; H02J7/00</td></tr>
<tr><td colspan="3">Documentation searched other than minimum documentation to the extent that such documents are included in the fields searched<br><br>Published examined utility model applications of Japan 1922-1996<br>Published unexamined utility model applications of Japan 1971-2023<br>Registered utility model specifications of Japan 1996-2023<br>Published registered utility model applications of Japan 1994-2023</td></tr>
<tr><td colspan="3">Electronic data base consulted during the international search (name of data base and, where practicable, search terms used)</td></tr>
</table>

### C. DOCUMENTS CONSIDERED TO BE RELEVANT

| Category* | Citation of document, with indication, where appropriate, of the relevant passages | Relevant to claim No. |
|---|---|---|
| X | JP 2016-134948 A (TOYOTA MOTOR CORP) 25 July 2016 (2016-07-25) paragraphs [0011]-[0044], fig. 1-2 | 1-4, 13-14, 18-21 |
| Y | | 15-17 |
| A | | 5-12 |
| Y | JP 2013-247023 A (TOYOTA INDUSTRIES CORP) 09 December 2013 (2013-12-09) paragraph [0013] | 15-17 |
| Y | JP 2021-191011 A (DENSO CORP) 13 December 2021 (2021-12-13) paragraphs [0013]-[0019], [0026], fig. 1 | 16-17 |

☐ Further documents are listed in the continuation of Box C.　　☑ See patent family annex.

<table>
<tr><td colspan="2">* Special categories of cited documents:</td></tr>
<tr><td>"A"</td><td>document defining the general state of the art which is not considered to be of particular relevance</td></tr>
<tr><td>"E"</td><td>earlier application or patent but published on or after the international filing date</td></tr>
<tr><td>"L"</td><td>document which may throw doubts on priority claim(s) or which is cited to establish the publication date of another citation or other special reason (as specified)</td></tr>
<tr><td>"O"</td><td>document referring to an oral disclosure, use, exhibition or other means</td></tr>
<tr><td>"P"</td><td>document published prior to the international filing date but later than the priority date claimed</td></tr>
<tr><td>"T"</td><td>later document published after the international filing date or priority date and not in conflict with the application but cited to understand the principle or theory underlying the invention</td></tr>
<tr><td>"X"</td><td>document of particular relevance; the claimed invention cannot be considered novel or cannot be considered to involve an inventive step when the document is taken alone</td></tr>
<tr><td>"Y"</td><td>document of particular relevance; the claimed invention cannot be considered to involve an inventive step when the document is combined with one or more other such documents, such combination being obvious to a person skilled in the art</td></tr>
<tr><td>"&"</td><td>document member of the same patent family</td></tr>
</table>

| Date of the actual completion of the international search | Date of mailing of the international search report |
|---|---|
| **06 June 2023** | **20 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/012834**

| Patent document cited in search report | | | Publication date (day/month/year) | Patent family member(s) | Publication date (day/month/year) |
|---|---|---|---|---|---|
| JP | 2016-134948 | A | 25 July 2016 | (Family: none) | |
| JP | 2013-247023 | A | 09 December 2013 | (Family: none) | |
| JP | 2021-191011 | A | 13 December 2021 | WO 2021-191011 A1 paragraphs [0013]-[0019], [0026], fig. 1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014178213 A